# EUROPEAN PATENT SPECIFICATION

(11) **EP 4 498 205 B1**
(45) Date of publication and mention of the grant of the patent: **25.02.2026**
(21) Application number: 23834443.6
(22) Date of filing: 12.04.2023
(51) Int. Cl.: G06F 1/16, G06F 1/20

(54) **LAPTOP**
LAPTOP
ORDINATEUR PORTABLE

(30) Priority: 07.07.2022 CN 202210803375
(43) Date of publication of application: 29.01.2025
(73) Proprietor: Honor Device Co., Ltd., Shenzhen, Guangdong 518040 (CN)
(72) Inventor: SUN, Guiping, Shenzhen, Guangdong 518040 (CN); ZHANG, Lukuan, Shenzhen, Guangdong 518040 (CN); ZHANG, Jianfei, Shenzhen, Guangdong 518040 (CN); CHEN, Jinyu, Shenzhen, Guangdong 518040 (CN)
(74) Representative: Isarpatent
(86) International application number: PCT/CN2023/087841
(87) International publication number: WO 2024/007660

(56) References cited:
- WO-A1-2021/115005
- CN-A- 105 652 991
- CN-A- 109 471 512
- US-A1- 2021 317 844

## Description

Priority is claimed to Chinese Patent Application No. 202210803375.6, filed with the China National Intellectual Property Administration on July 7, 2022 and entitled "NOTEBOOK COMPUTER"

### TECHNICAL FIELD

This application relates to the field of terminal product technologies, and in particular, to a notebook computer.

### BACKGROUND

With development of technologies, a performance requirement of a user on a notebook computer is increasingly high. Accordingly, devices such as a central processing unit (central processing unit, CPU), an electronic device in a CPU power supply circuit, a graphics processing unit (graphics processing unit, GPU), an electronic device in a GPU power supply circuit, and a video random access memory (video random access memory, VRAM) in the notebook computer generate more heat.

An existing notebook computer usually transfers heat of a heat generation device on a circuit board to a fin by using a heat dissipation plate and a heat pipe, and performs, at the fin, heat exchange with air generated by a fan. A heat transfer path is as follows: heat generation device - heat dissipation plate → heat pipe → fin → air generated by the fan. The heat dissipation path is long, and is affected by factors such as thermal resistance of a connection part between the heat dissipation plate and the heat generation device, thermal resistance of the heat dissipation plate, thermal resistance of the heat pipe, thermal resistance of a welding part between the heat pipe and the fin, a heat dissipation area of the fin, and performance of the fan. As a result, heat dissipation efficiency is low, and heat cannot be effectively exchanged with the outside. Consequently, surface temperature of the entire computer is excessively high, and performance and user experience thereof are low.

CN 109471512 A discloses a cooling heat exchange system and a notebook computer. The cooling heat exchange system is applied to electronic equipment. The cooling heat exchange system comprises a firstheat dissipation module and a second heat dissipation module. Wherein the first heat dissipation module is in a working state when the working state parameter of the electronic device satisfies the first condition; The first heat dissipation module operates simultaneously with the second heat dissipation module when the operating state parameter of the electronic device satisfies a second condition. By using two sets of heat dissipation modules together, the disclosure can meet the heat dissipation requirements of electronic equipment under different working modes, and effectively improves theheat dissipation performance of the electronic equipment.

### SUMMARY

The object of the present invention is to provide a notebook computer, to resolve a problem of how to improve heat dissipation efficiency of the notebook computer. This object is solved by the attached independent claims and further embodiments and improvements of the invention are listed in the attached dependent claims. Hereinafter, up to the "brief description of the drawings", expressions like "...aspect according to the invention", "according to the invention", or "the present invention", relate to technical teaching of the broadest embodiment as claimed with the independent claims. Expressions like "implementation", "design", "optionally", "preferably", "scenario", "aspect" or similar relate to further embodiments as claimed, and expressions like "example", "...aspect according to an example", "the disclosure describes", or "the disclosure" describe technical teaching which relates to the understanding of the invention or its embodiments, which, however, is not claimed as such.

To achieve the foregoing objective, the following technical solutions are used in the embodiments of this application.

According to a first aspect according to the invention, a notebook computer is provided, where the notebook computer includes a host, and the host includes a host housing, two first fans, and a second fan. The host housing includes a first wall plate and a second wall plate that are opposite to each other and that are spaced apart, and a third wall plate connected between the first wall plate and the second wall plate. A first air outlet structure is disposed on the second wall plate and/or the third wall plate. The two first fans are disposed in the host housing, the two first fans are arranged at intervals, and an arrangement direction of the two first fans is parallel to the second wall plate. The second fan is disposed in the host housing, and is located between the foregoing two first fans. The second fan has an air outlet, and the air outlet of the second fan communicates with the first air outlet structure.

In this way, the two first fans can take away a part of heat in the host. In addition, when the second fan runs, another part of heat in the host can be taken away, so that heat dissipation efficiency of the host can be improved.

According to the invention of the first aspect, the host further includes a circuit board assembly and a heat dissipation plate. The circuit board assembly is disposed in the host housing, and the circuit board assembly includes a circuit board and at least one heat generation device disposed on the circuit board. The heat dissipation plate is disposed between the circuit board assembly and the second wall plate, and the heat dissipation plate is thermally conductive with the at least one heat generation device. The second fan includes at least one fan body and a fan housing. The at least one fan body is located on a side that is of the heat dissipation plate and that is away from the circuit board assembly, that is, the at least one fan body is located between the heat dissipation plate and the second wall plate. The fan housing covers the outside of the at least one fan body, and the heat dissipation plate forms one wall plate of the fan housing.

In this way, a housing structure of the second fan is no longer separately disposed in this implementation. Instead, the heat dissipation plate is directly used as a part of the housing of the second fan. Therefore, after heat generated by the heat generation device is transferred to the heat dissipation plate, the heat can be directly exchanged with an airflow in an internal space of the fan housing, and is further brought out to the outside of the host by the first air outlet structure. A heat transfer path is as follows: heat generation device → heat dissipation plate → airflow in the internal space of the fan housing. The heat transfer path is short, and heat dissipation efficiency is high. Therefore, this can avoid excessively high surface temperature of the entire computer, and improve performance and user experience of the entire computer. In addition, because the heat dissipation plate forms one wall plate of the fan housing, heights of the fan housing of the second fan and the heat dissipation plate are prevented from being superposed in a thickness direction of the host, to facilitate thinning of a thickness of the host. In another aspect, a space between the heat dissipation plate and the second wall plate is narrow when the thickness of the host is fixed. On this basis, because the heat dissipation plate forms one wall plate of the fan housing of the second fan, it is convenient to mount the second fan in the narrow space between the heat dissipation plate and the second wall plate.

In some possible implementations of the first aspect, the second wall plate forms another wall plate that is of the fan housing and that is opposite to the heat dissipation plate. In this way, heights of the fan housing and the second wall plate can be prevented from being superposed in the thickness direction of the host, to facilitate thinning of the thickness of the host. In another aspect, it is convenient to mount the second fan in the narrow space between the heat dissipation plate and the second wall plate.

In some possible implementations of the first aspect, the fan body includes a central shaft and a plurality of blades disposed around the central shaft, the central shaft of the at least one fan body is perpendicular to the second wall plate, and the blade of the at least one fan body is a centrifugal blade. In this way, the second fan is a centrifugal fan, and a size of the centrifugal fan in an axial direction of the centrifugal fan is small, to facilitate mounting in the narrow space between the heat dissipation plate and the second wall plate.

In some possible implementations of the first aspect, there are a plurality of fan bodies, and the plurality of fan bodies are arranged at intervals in a direction parallel to the third wall plate. In this way, an air volume can be increased. In addition, distances from the plurality of fan bodies to the first air outlet structure are approximately equal, so that airflows generated by the plurality of fan bodies can be prevented from affecting each other.

In some possible implementations of the first aspect, a separator is disposed between two adjacent fan bodies, the separator separates an internal space of the fan housing into a plurality of sub-spaces, and the plurality of fan bodies are respectively located in the plurality of sub-spaces; and the internal space of the fan housing further includes a main space located between the plurality of sub-spaces and the first air outlet structure, the plurality of sub-spaces communicate with the main space, and the main space communicates with the first air outlet structure. In this way, the airflow generated by the fan body enters the main space along the plurality of sub-spaces, and is further discharged from the first air outlet structure through the main space. The separator can prevent airflows generated by the two adjacent fan bodies from affecting each other.

According to the invention of the first aspect, the host further includes a heat dissipation fin, the heat dissipation fin is disposed on a surface that is of the heat dissipation plate and that is away from the circuit board assembly, and the heat dissipation fin is located in the internal space of the fan housing. In this way, a heat exchange area between the heat dissipation plate and the airflow in the fan housing can be increased by using the heat dissipation fin, thereby improving heat dissipation efficiency.

According to the invention of the first aspect, there are a plurality of heat dissipation fins, the plurality of heat dissipation fins form at least one heat dissipation fin group, and a quantity of the at least one heat dissipation fin group is equal to a quantity of the at least one fan body and the at least one heat dissipation fin group is in a one-to-one correspondence with the at least one fan body; the fan body has a first side and a second side that are opposite to each other, and an arrangement direction of the first side, the fan body, and the second side is parallel to the third wall plate; the heat dissipation fin group corresponding to the fan body includes two rows of first heat dissipation fins, and the two rows of first heat dissipation fins are respectively located on the first side and the second side of the fan body; and each row of first heat dissipation fins includes a plurality of first heat dissipation fins, the plurality of first heat dissipation fins are arranged at intervals in a direction perpendicular to the third wall plate, and each first heat dissipation fin extends in the direction parallel to the third wall plate. In this way, the first heat dissipation fins are located on two opposite sides of the fan body, and an airflow generated by the fan body through rotation may enter a gap between two adjacent first heat dissipation fins, to fully exchange heat with the first heat dissipation fins, thereby improving heat exchange efficiency. In addition, extension directions of the first heat dissipation fins in the two rows of first heat dissipation fins are the same, so that a structure is simple, and processing costs are low.

In some possible implementations of the first aspect, an occupation region, on the heat dissipation plate, of the at least one fan body and the two rows of first heat dissipation fins in the heat dissipation fin group respectively corresponding to the at least one fan body is a first region; the at least one heat generation device includes a first group of heat generation devices; and an orthogonal projection of the first group of heat generation devices on the heat dissipation plate overlaps the first region. In this way, heat dissipation efficiency of the first group of heat generation devices can be improved.

In some possible but not claimed implementations of the first aspect, the first group of heat generation devices includes a CPU MOS and a GPU MOS.

In some possible implementations of the first aspect, the heat dissipation fin group corresponding to the fan body further includes a plurality of second heat dissipation fins; and the plurality of second heat dissipation fins are located between the fan body and the first air outlet structure, the plurality of second heat dissipation fins are arranged at intervals in the direction parallel to the third wall plate, and each second heat dissipation fin extends in the direction perpendicular to the third wall plate. In this way, an airflow that flows from the fan body to the first air outlet structure may pass through the plurality of second heat dissipation fins, so that heat exchange efficiency can be further improved.

In some possible implementations of the first aspect, the plurality of second heat dissipation fins are further located between the two rows of first heat dissipation fins and the first air outlet structure, and the plurality of second heat dissipation fins are spaced apart from the two rows of first heat dissipation fins. In this way, there is a first gap between the plurality of second heat dissipation fins and the two rows of first heat dissipation fins. The airflow generated by the fan body may flow in a length direction of the first gap, and enter a gap between two adjacent second heat dissipation fins from the first gap, so that the airflow can pass through gaps between the plurality of second heat dissipation fins, to improve heat exchange efficiency.

In some possible implementations of the first aspect, an occupation region, on the heat dissipation plate, of the plurality of second heat dissipation fins in the heat dissipation fin group respectively corresponding to the at least one fan body is a second region; the at least one heat generation device further includes a second group of heat generation devices; and an orthogonal projection of the second group of heat generation devices on the heat dissipation plate overlaps the second region. In this way, heat dissipation efficiency of the second group of heat generation devices can be improved by using the plurality of second heat dissipation fins.

In some possible but not claimed implementations of the first aspect, the second group of heat generation devices includes a CPU inductor and a GPU inductor.

In some possible implementations of the first aspect, the host further includes a heat pipe and two groups of fins; the heat pipe includes an evaporation section and two condensation sections, the evaporation section is located on a side that is of the heat dissipation plate and that is away from the circuit board assembly, the evaporation section is thermally conductive with the heat dissipation plate, and the two condensation sections are respectively connected to two ends of the evaporation section in a length direction; the two groups of fins are respectively disposed outside the two condensation sections, and are thermally conductive with pipe housings of the two condensation sections; and the two groups of fins are located on air outlet sides of the two first fans. In this way, a heat transfer path of the circuit board assembly further includes: heat generation device → heat dissipation plate → evaporation section of the heat pipe → condensation section → fin → airflow generated by the first fan, to further dissipate heat for the heat generation device, and improve heat dissipation efficiency.

In some possible implementations of the first aspect, the evaporation section is located in the internal space of the fan housing, and the evaporation section is located on a side that is of the plurality of second heat dissipation fins and that is away from the fan body. In this way, heat of the evaporation section is transferred to the condensation section, to be further carried to the outside of the host by the airflow generated by the first fan. In addition, the heat of the evaporation section is further in direct contact with the airflow in the fan housing for heat exchange, to be directly carried to the outside of the host by the airflow generated by the second fan. Therefore, heat dissipation efficiency of the circuit board assembly can be improved. In addition, after the airflow in the fan housing exchanges heat with the first group of heat generation devices and the second group of heat generation devices, the airflow is in contact with the evaporation section for heat exchange, so that heat dissipation efficiency of the first group of heat generation devices and the second group of heat generation devices can be ensured.

In some possible implementations of the first aspect, the at least one heat generation device further includes a third group of heat generation devices, and an orthogonal projection of the third group of heat generation devices on the heat dissipation plate overlaps an orthogonal projection of the evaporation section on the heat dissipation plate. In this way, a heat transfer path between the evaporation section and the third group of heat generation devices is short, so that heat dissipation efficiency of the third group of heat generation devices can be improved.

In some possible but not claimed implementations of the first aspect, the third group of heat generation devices includes a CPU and a GPU.

In some possible implementations of the first aspect, the host further includes an air baffle strip, the air baffle strip is disposed between the heat dissipation plate and the second wall plate, and surrounds the at least one fan body, and the air baffle strip forms a side wall of the fan housing. In this way, it is convenient to concentrate airflows, to ensure heat dissipation efficiency. A position of the air baffle strip may be set based on a requirement. Optionally, the air baffle strip is disposed between the two first fans, to prevent the airflow in the fan housing and another airflow (for example, the airflow generated by the first fan) in the host from affecting each other.

In some possible implementations of the first aspect, the heat dissipation plate includes a heat dissipation plate body and a thermally conductive insert; and an opening is disposed at a position that is on the heat dissipation plate body and that is opposite to the heat generation device, the thermally conductive insert is disposed in the opening, the heat generation device is thermally conductive with the thermally conductive insert, and an edge of the thermally conductive insert is thermally conductive with an edge of the heat dissipation plate body at the opening. In this way, the heat dissipation plate body and the thermally conductive insert may be molded by using different materials, to consider both heat dissipation performance and structural molding difficulty of the heat dissipation plate. Specifically, the heat dissipation plate body may be made of a structure with low molding difficulty such as aluminum, an aluminum alloy, and magnalium, and the thermally conductive insert may be made of a material with a high thermal conductivity such as copper, a copper alloy, and graphite, to consider both heat dissipation performance and structural molding difficulty of the heat dissipation plate.

In some possible implementations of the first aspect, the host further includes a detection apparatus and a controller; the detection apparatus is configured to detect power consumption of the at least one heat generation device; and the controller is electrically connected to the detection apparatus and the second fan, and the controller is configured to control running of the second fan based on power consumption of the at least one heat generation device detected by the detection apparatus. In this way, the second fan is started only when the at least one heat generation device runs with full load, so that a problem of large noise can be resolved to some extent, thereby improving user experience.

According to a second aspect, wherein the second aspect and any of its implementations and options below, while sharing some features with the first aspect of the invention for illustrating features thereof, are not claimed as such, a notebook computer is provided, where the notebook computer includes a host, and the host includes a host housing, a circuit board assembly, a heat dissipation plate, and a second fan. The host housing includes a first wall plate and a second wall plate opposite to the first wall plate. The circuit board assembly is disposed in the host housing, and the circuit board assembly includes a circuit board and at least one heat generation device disposed on the circuit board. The heat dissipation plate is disposed between the circuit board assembly and the second wall plate, and the heat dissipation plate is thermally conductive with the at least one heat generation device. The first fan includes at least one fan body and a fan housing. The at least one fan body is located on a side that is of the heat dissipation plate and that is away from the circuit board assembly, that is, the at least one fan body is located between the heat dissipation plate and the second wall plate. The fan housing covers the outside of the at least one fan body, and the heat dissipation plate forms one wall plate of the fan housing.

In this way, after heat generated by the heat generation device is transferred to the heat dissipation plate, the heat can be directly exchanged with an airflow in an internal space of the fan housing, and is further brought out to the outside of the host by the airflow. A heat transfer path is as follows: heat generation device → heat dissipation plate → airflow in the internal space of the fan housing. The heat transfer path is short, and heat dissipation efficiency is high. Therefore, this can avoid excessively high surface temperature of the entire computer, and improve performance and user experience of the entire computer. In addition, because the heat dissipation plate forms one wall plate of the fan housing, heights of the fan housing of the second fan and the heat dissipation plate are prevented from being superposed in a thickness direction of the host, to facilitate thinning of a thickness of the host. In another aspect, a space between the heat dissipation plate and the second wall plate is narrow when the thickness of the host is fixed. On this basis, because the heat dissipation plate forms one wall plate of the fan housing of the second fan, it is convenient to mount the second fan in the narrow space between the heat dissipation plate and the second wall plate.

In some possible implementations of the second aspect, the second wall plate forms another wall plate that is of the fan housing and that is opposite to the heat dissipation plate. In this way, heights of the fan housing and the second wall plate can be prevented from being superposed in the thickness direction of the host, to facilitate thinning of the thickness of the host. In another aspect, it is convenient to mount the second fan in the narrow space between the heat dissipation plate and the second wall plate.

In some possible implementations of the second aspect, the fan body includes a central shaft and a plurality of blades disposed around the central shaft, the central shaft of the at least one fan body is perpendicular to the second wall plate, and the blade of the at least one fan body is a centrifugal blade. In this way, the second fan is a centrifugal fan, and a size of the centrifugal fan in an axial direction of the centrifugal fan is small, to facilitate mounting in the narrow space between the heat dissipation plate and the second wall plate.

In some possible implementations of the second aspect, the host housing further includes a third wall plate connected between the first wall plate and the second wall plate, and a first air outlet structure is disposed on the second wall plate and/or the third wall plate; and the second fan has an air outlet, and the air outlet of the second fan communicates with the first air outlet structure.

In some possible implementations of the second aspect, there are a plurality of fan bodies; and the plurality of fan bodies are arranged at intervals in a direction parallel to the third wall plate. In this way, an air volume can be increased. In addition, distances from the plurality of fan bodies to the first air outlet structure are approximately equal, so that airflows generated by the plurality of fan bodies can be prevented from affecting each other.

In some possible implementations of the second aspect, a separator is disposed between two adjacent fan bodies, the separator separates an internal space of the fan housing into a plurality of sub-spaces, and the plurality of fan bodies are respectively located in the plurality of sub-spaces; and the internal space of the fan housing further includes a main space located between the plurality of sub-spaces and the first air outlet structure, the plurality of sub-spaces communicate with the main space, and the main space communicates with the first air outlet structure. In this way, the airflow generated by the fan body enters the main space along the plurality of sub-spaces, and is further discharged from the first air outlet structure through the main space. The separator can prevent airflows generated by the two adjacent fan bodies from affecting each other.

In some possible implementations of the second aspect, the host further includes a heat dissipation fin, the heat dissipation fin is disposed on a surface that is of the heat dissipation plate and that is away from the circuit board assembly, and the heat dissipation fin is located in the internal space of the fan housing. In this way, a heat exchange area between the heat dissipation plate and the airflow in the fan housing can be increased by using the heat dissipation fin, thereby improving heat dissipation efficiency.

In some possible implementations of the second aspect, there are a plurality of heat dissipation fins, the plurality of heat dissipation fins form at least one heat dissipation fin group, and a quantity of the at least one heat dissipation fin group is equal to a quantity of the at least one fan body and the at least one heat dissipation fin group is in a one-to-one correspondence with the at least one fan body; the fan body has a first side and a second side that are opposite to each other, and an arrangement direction of the first side, the fan body, and the second side is parallel to the third wall plate; the heat dissipation fin group corresponding to the fan body includes two rows of first heat dissipation fins, and the two rows of first heat dissipation fins are respectively located on the first side and the second side of the fan body; and each row of first heat dissipation fins includes a plurality of first heat dissipation fins, the plurality of first heat dissipation fins are arranged at intervals in a direction perpendicular to the third wall plate, and each first heat dissipation fin extends in the direction parallel to the third wall plate. In this way, the first heat dissipation fins are located on two opposite sides of the fan body, and an airflow generated by the fan body through rotation may enter a gap between two adjacent first heat dissipation fins, to fully exchange heat with the first heat dissipation fins, thereby improving heat exchange efficiency. In addition, extension directions of the first heat dissipation fins in the two rows of first heat dissipation fins are the same, so that a structure is simple, and processing costs are low.

In some possible implementations of the second aspect, an occupation region, on the heat dissipation plate, of the at least one fan body and the two rows of first heat dissipation fins in the heat dissipation fin group respectively corresponding to the at least one fan body is a first region; the at least one heat generation device includes a first group of heat generation devices; and an orthogonal projection of the first group of heat generation devices on the heat dissipation plate overlaps the first region. In this way, heat dissipation efficiency of the first group of heat generation devices can be improved.

In some possible implementations of the second aspect, the first group of heat generation devices includes a CPU MOS and a GPU MOS.

In some possible implementations of the second aspect, the heat dissipation fin group corresponding to the fan body further includes a plurality of second heat dissipation fins; and the plurality of second heat dissipation fins are located between the fan body and the first air outlet structure, the plurality of second heat dissipation fins are arranged at intervals in the direction parallel to the third wall plate, and each second heat dissipation fin extends in the direction perpendicular to the third wall plate. In this way, an airflow that flows from the fan body to the first air outlet structure may pass through the plurality of second heat dissipation fins, so that heat exchange efficiency can be further improved.

In some possible implementations of the second aspect, the plurality of second heat dissipation fins are further located between the two rows of first heat dissipation fins and the first air outlet structure, and the plurality of second heat dissipation fins are spaced apart from the two rows of first heat dissipation fins. In this way, there is a first gap between the plurality of second heat dissipation fins and the two rows of first heat dissipation fins. The airflow generated by the fan body may flow in a length direction of the first gap, and enter a gap between two adjacent second heat dissipation fins from the first gap, so that the airflow can pass through gaps between the plurality of second heat dissipation fins, to improve heat exchange efficiency.

In some possible implementations of the second aspect, an occupation region, on the heat dissipation plate, of the plurality of second heat dissipation fins in the heat dissipation fin group respectively corresponding to the at least one fan body is a second region; the at least one heat generation device further includes a second group of heat generation devices; and an orthogonal projection of the second group of heat generation devices on the heat dissipation plate overlaps the second region. In this way, heat dissipation efficiency of the second group of heat generation devices can be improved by using the plurality of second heat dissipation fins.

In some possible implementations of the second aspect, the second group of heat generation devices includes a CPU inductor and a GPU inductor.

In some possible implementations of the second aspect, the host further includes a heat pipe, at least one group of fins, and at least one first fan; the heat pipe includes an evaporation section and at least one condensation section, the evaporation section is located on a side that is of the heat dissipation plate and that is away from the circuit board assembly, and the evaporation section is thermally conductive with the heat dissipation plate; the at least one group of fins is disposed outside the at least one condensation section, and is thermally conductive with a pipe housing of the at least one condensation section; and the at least one group of fins is located on an air outlet side of the at least one first fan. In this way, a heat transfer path of the circuit board assembly further includes: heat generation device → heat dissipation plate → evaporation section of the heat pipe → condensation section → fin → airflow generated by the first fan, to further dissipate heat for the heat generation device, and improve heat dissipation efficiency.

In some possible implementations of the second aspect, the evaporation section is located in the internal space of the fan housing, and the evaporation section is located on a side that is of the plurality of second heat dissipation fins and that is away from the fan body. In this way, heat of the evaporation section is transferred to the condensation section, to be further carried to the outside of the host by the airflow generated by the first fan. In addition, the heat of the evaporation section is further in direct contact with the airflow in the fan housing for heat exchange, to be directly carried to the outside of the host by the airflow generated by the second fan. Therefore, heat dissipation efficiency of the circuit board assembly can be improved. In addition, after the airflow in the fan housing exchanges heat with the first group of heat generation devices and the second group of heat generation devices, the airflow is in contact with the evaporation section for heat exchange, so that heat dissipation efficiency of the first group of heat generation devices and the second group of heat generation devices can be ensured.

In some possible implementations of the second aspect, the at least one heat generation device further includes a third group of heat generation devices, and an orthogonal projection of the third group of heat generation devices on the heat dissipation plate overlaps an orthogonal projection of the evaporation section on the heat dissipation plate. In this way, a heat transfer path between the evaporation section and the third group of heat generation devices is short, so that heat dissipation efficiency of the third group of heat generation devices can be improved.

In some possible implementations of the second aspect, the third group of heat generation devices includes a CPU and a GPU.

In some possible implementations of the second aspect, the host further includes an air baffle strip, where the air baffle strip is disposed between the heat dissipation plate and the second wall plate, and surrounds the at least one fan body, and the air baffle strip forms a side wall of the fan housing. In this way, it is convenient to concentrate airflows, to ensure heat dissipation efficiency. A position of the air baffle strip may be set based on a requirement. Optionally, the air baffle strip is disposed between the two first fans, to prevent the airflow in the fan housing and another airflow (for example, the airflow generated by the first fan) in the host from affecting each other.

In some possible implementations of the second aspect, the heat dissipation plate includes a heat dissipation plate body and a thermally conductive insert; and an opening is disposed at a position that is on the heat dissipation plate body and that is opposite to the heat generation device, the thermally conductive insert is disposed in the opening, the heat generation device is thermally conductive with the thermally conductive insert, and an edge of the thermally conductive insert is thermally conductive with an edge of the heat dissipation plate body at the opening. In this way, the heat dissipation plate body and the thermally conductive insert may be molded by using different materials, to consider both heat dissipation performance and structural molding difficulty of the heat dissipation plate. Specifically, the heat dissipation plate body may be made of a structure with low molding difficulty such as aluminum, an aluminum alloy, and magnalium, and the thermally conductive insert may be made of a material with a high thermal conductivity such as copper, a copper alloy, and graphite, to consider both heat dissipation performance and structural molding difficulty of the heat dissipation plate.

In some possible implementations of the second aspect, the host further includes a detection apparatus and a controller; the detection apparatus is configured to detect power consumption of the at least one heat generation device; and the controller is electrically connected to the detection apparatus and the second fan, and the controller is configured to control running of the second fan based on power consumption of the at least one heat generation device detected by the detection apparatus. In this way, the second fan is started only when the at least one heat generation device runs with full load, so that a problem of large noise can be resolved to some extent, thereby improving user experience.

In the following description, features which in the above summary of the invention have been marked as "not claimed" or "according to the invention" are also hereinafter, when they are described and explained with reference to the drawings, to be understood as "not claimed" or "not part of the invention" or "according to the invention". Even if sometimes in the description of the embodiments below, features marked above "according to the invention" or "the invention" are referred to in connection with the words "can" or "may" or other expressions which contain the notion of them being "optional", it should be understood that indeed such features are considered essential to the invention as claimed and not optional.

### BRIEF DESCRIPTION OF DRAWINGS

FIG. 1 is a schematic diagram of a structure of a notebook computer according to some embodiments of this application;
FIG. 2 is a schematic diagram of a structure of a host in the notebook computer shown in FIG. 1;
FIG. 3 is a schematic diagram of a structure existing when the host shown in FIG. 2 is viewed from a direction D1 (from bottom to top);
FIG. 4 is a schematic diagram of a structure existing when the host shown in FIG. 2 is viewed from a direction D2 (from back to front);
FIG. 5 is an exploded view of the host shown in FIG. 2;
FIG. 6 is a schematic diagram of a structure existing when the exploded view shown in FIG. 5 is viewed from bottom to top;
FIG. 7 is a schematic diagram of a structure of a lower surface of a circuit board assembly in the host shown in FIG. 6;
FIG. 8 is a schematic diagram of a structure existing when a first heat dissipation system in the host shown in FIG. 5 is viewed from bottom to top;
FIG. 9 is an exploded view of the first heat dissipation system shown in FIG. 8;
FIG. 10 is an exploded view of a heat dissipation plate in the first heat dissipation system shown in FIG. 9 and a circuit board assembly;
FIG. 11 is a schematic diagram of positions of a thermally conductive pad and a thermally conductive paste on the heat dissipation plate in FIG. 10;
FIG. 12 is a schematic diagram of a structure of a surface that is of the heat dissipation plate in FIG. 11 and on which a thermally conductive pad and a thermally conductive paste are disposed;
FIG. 13 is an exploded view of the heat dissipation plate shown in FIG. 12;
FIG. 14 is a schematic diagram of an assembly structure of a second heat dissipation system and a circuit board assembly in the host shown in FIG. 5 and FIG. 6;
FIG. 15 is an exploded view of the second heat dissipation system in the assembly diagram shown in FIG. 14;
FIG. 16 is an assembly diagram of the second heat dissipation system, the circuit board assembly, and the first heat dissipation system shown in FIG. 14;
FIG. 17 is a front view of the second heat dissipation system in the assembly structure shown in FIG. 14 and a third wall plate of a host housing;
FIG. 18 is a schematic diagram of a projection, on a heat dissipation plate, of a heat generation device in the host shown in FIG. 6; and
FIG. 19 is a schematic diagram of an assembly structure of a circuit board assembly, a first heat dissipation system, and a second heat dissipation system in FIG. 5 and FIG. 6.

### DESCRIPTION OF EMBODIMENTS

In the embodiments of this application, terms "first", "second", "third", "fourth", "fifth", and "sixth" are merely used for description, and should not be understood as an indication or implication of relative importance or an implicit indication of a quantity of the indicated technical features. Therefore, a feature defined by "first", "second", "third", "fourth", "fifth", and "sixth" may explicitly or implicitly include one or more features.

In the embodiments of this application, the term "include", "comprise", or any other variant thereof is intended to cover non-exclusive inclusion, so that a process, method, article, or apparatus that includes a series of elements includes not only those elements, but also other elements that are not explicitly listed, or includes elements inherent to such a process, method, article, or apparatus. Without further limitation, an element defined by the sentence "including a..." does not exclude existence of other identical elements in the process, method, article, or apparatus including the element.

In the embodiments of this application, the term "and/or" is merely used to describe an association relationship between associated objects, and represents that three relationships may exist. For example, A and/or B may represent the following three cases: Only A exists, both A and B exist, and only B exists. In addition, the character "/" in this specification usually represents an "or" relationship between associated objects.

In the embodiments of this application, it should be noted that descriptions "perpendicular" and "parallel" respectively represent that approximate perpendicular and approximate parallel within a specific error range are allowed, and the error range may be a range in which a deviation angle relative to each of absolute perpendicular and absolute parallel is less than or equal to 5°, 8°, or 10°. This is not specifically limited herein.

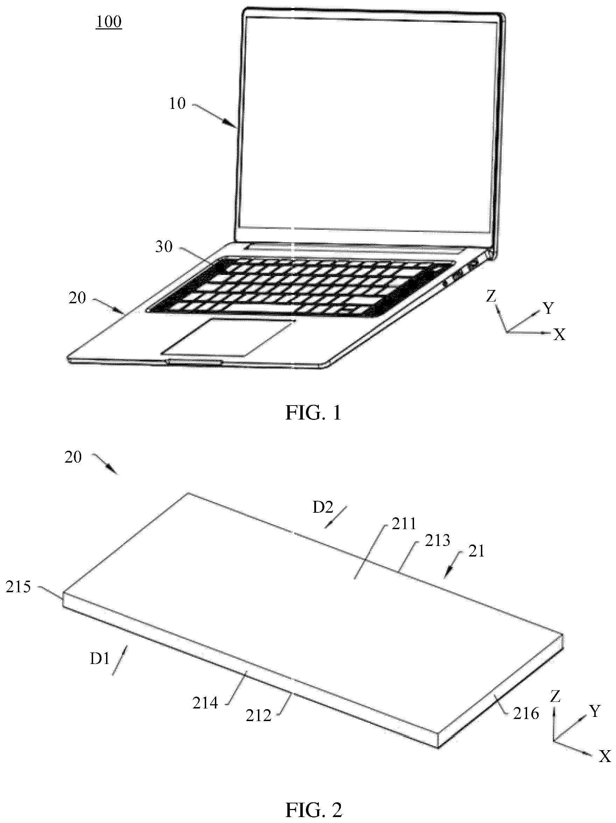

This application provides a notebook computer. Specifically, the notebook computer may be a common notebook computer or a gamebook computer. Reference is made to FIG. 1.

FIG. 1 is a schematic diagram of a structure of a notebook computer 100 according to some embodiments of this application. In this embodiment, the notebook computer 100 includes a display 10, a host 20, and a keyboard 30.

The display 10 is configured to display an image, a video, and the like. The keyboard 30 is configured to input an instruction or data, and the keyboard 30 is disposed on the host 20. The host 20 serves as a control center of the notebook computer 100, and is configured to implement functions such as data storage, operation, control, and signal conversion. The host 20 is rotatably connected to the display 10. The notebook computer 100 can switch between an open state and a closed state. When the notebook computer 100 is in an open state, referring to FIG. 1, the notebook computer 100 shown in FIG. 1 is in an open state, and the display 10 is opened at an angle relative to the host 20, where the angle may be greater than 0° and less than 180°. When the notebook computer 100 is in a closed state, the display 10 covers a surface that is of the host 20 and on which the keyboard 30 is disposed.

The following mainly describes the host 20.

Still referring to FIG. 1, the host 20 is substantially in a shape of a rectangular flat plate. On this basis, to facilitate description of the following embodiments, an XYZ coordinate system is established, a length direction of the host 20 is defined as an X-axis direction, a width direction of the host 20 is defined as a Y-axis direction, and a thickness direction of the host 20 is defined as a Z-axis direction. It may be understood that the coordinate system of the host 20 may be flexibly set based on an actual requirement. This is not specifically limited herein. In some other embodiments, the host 20 may alternatively be in a shape of a square flat plate, a circular flat plate, an elliptical flat plate, or the like.

Reference is made to FIG. 2. FIG. 2 is a schematic diagram of a structure of a host 20 in the notebook computer 100 shown in FIG. 1. The host 20 includes a host housing 21. The host housing 21 is configured to protect an internal electronic device. The host housing 21 includes a first wall plate 211 and a second wall plate 212 that are opposite to each other, a third wall plate 213 and a fourth wall plate 214 that are opposite to each other, and a fifth wall plate 215 and a sixth wall plate 216 that are opposite to each other. In some embodiments, referring to FIG. 2, the first wall plate 211 and the second wall plate 212 are arranged along the Z-axis. The first wall plate 211 is a top wall plate of the host housing 21, and the keyboard 30 is disposed on the first wall plate 211. The second wall plate 212 is a bottom wall plate of the host housing 21. The third wall plate 213 and the fourth wall plate 214 are arranged along the Y-axis. The third wall plate 213 is a back wall plate of the host housing 21, and the display 10 may be rotatably connected to the third wall plate 213. The fourth wall plate 214 is a front wall plate of the host housing 21. The fifth wall plate 215 and the sixth wall plate 216 are arranged along the X-axis. The fifth wall plate 215 is a left wall plate of the host housing 21. The sixth wall plate 216 is a right wall plate of the host housing 21. Certainly, the first wall plate 211, the second wall plate 212, the third wall plate 213, the fourth wall plate 214, the fifth wall plate 215, and the sixth wall plate 216 may be other wall plates. This is not specifically limited herein.

The host housing 21 may be an integral structural member, or may be formed by assembling a plurality of parts. This is not specifically limited herein. In some embodiments, the first wall plate 211, the third wall plate 213, the fourth wall plate 214, the fifth wall plate 215, and the sixth wall plate 216 are an integral structural member to form a C shell. The second wall plate 212 is a D shell. The C shell and the D shell are assembled to form the host housing 21. In this way, structure composition of the host housing 21 can be simplified, and assembly difficulty thereof can be reduced. In addition, it is convenient for assembly of an internal electronic device.

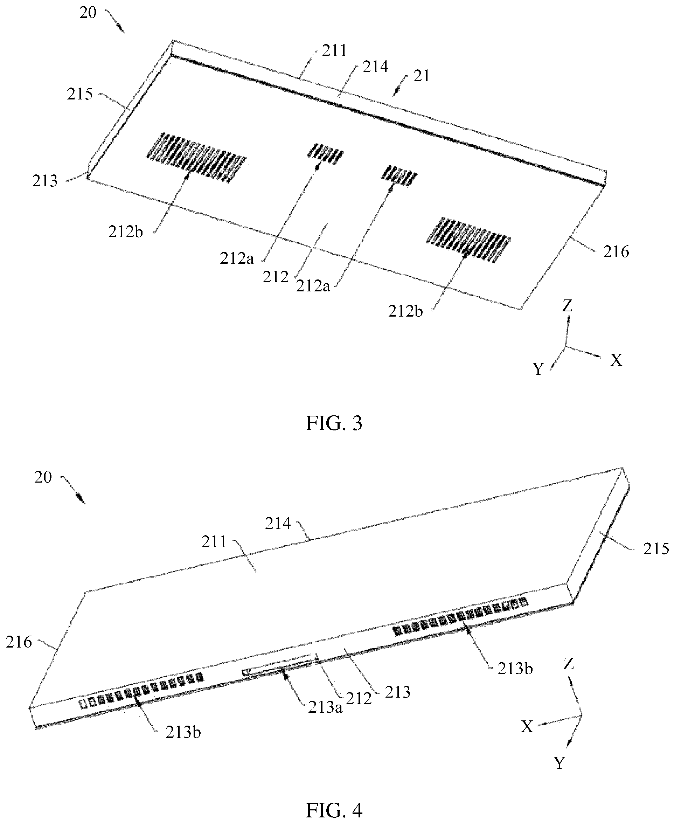

Reference is made to FIG. 3. FIG. 3 is a schematic diagram of a structure existing when the host 20 shown in FIG. 2 is viewed from a direction D1 (from bottom to top). At least one first air inlet structure 212a and at least one second air inlet structure 212b are disposed on the second wall plate 212. In some embodiments, there are two first air inlet structures 212a and two second air inlet structures 212b.

Reference is made to FIG. 4. FIG. 4 is a schematic diagram of a structure existing when the host 20 shown in FIG. 2 is viewed from a direction D2 (from back to front). At least one first air outlet structure 213a and at least one second air outlet structure 213b are disposed on the third wall plate 213. In some embodiments, there is one first air outlet structure 213a, and there are two second air outlet structures 213b.

External air may enter the host 20 from the at least one first air inlet structure 212a and the at least one second air inlet structure 212b, and is discharged from the at least one first air outlet structure 213a and the at least one second air outlet structure 213b after heat exchange with the internal electronic device of the host 20, to perform heat dissipation processing on the host 20. In some other embodiments, the first air inlet structure 212a, the second air inlet structure 212b, the first air outlet structure 213a, and the second air outlet structure 213b may be disposed on other wall plates. This is not specifically limited herein. For example, the first air outlet structure 213a may be disposed on the second wall plate 212. Optionally, the first air outlet structure 213a is disposed in a region that is on the second wall plate 212 and that is connected to the third wall plate 213. This is not specifically limited herein.

In the foregoing embodiment, the first air inlet structure 212a, the second air inlet structure 212b, the first air outlet structure 213a, and the second air outlet structure 213b communicate an inner side of the host housing 21 with an outer side thereof. In some embodiments, referring to FIG. 3 and FIG. 4, the first air inlet structure 212a, the second air inlet structure 212b, and the second air outlet structure 213b are all of grid structures, so that foreign matter is prevented from entering the host housing 20. The first air outlet structure 213a is of an open structure. Optionally, a height of the first air outlet structure 213a in the Z-axis direction is less than a height of the second air outlet structure 213b in the Z-axis direction. In this way, the foreign matter can also be prevented from entering the host housing without disposing a grid. In some other embodiments, the first air inlet structure 212a, the second air inlet structure 212b, and the second air outlet structure 213b each may alternatively be of an open structure or a mesh structure, and the first air outlet structure 213a may also be of a grid structure or a mesh structure.

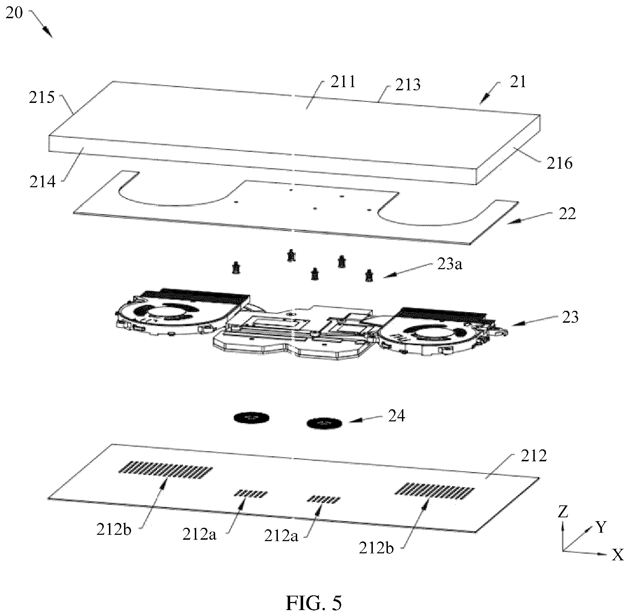

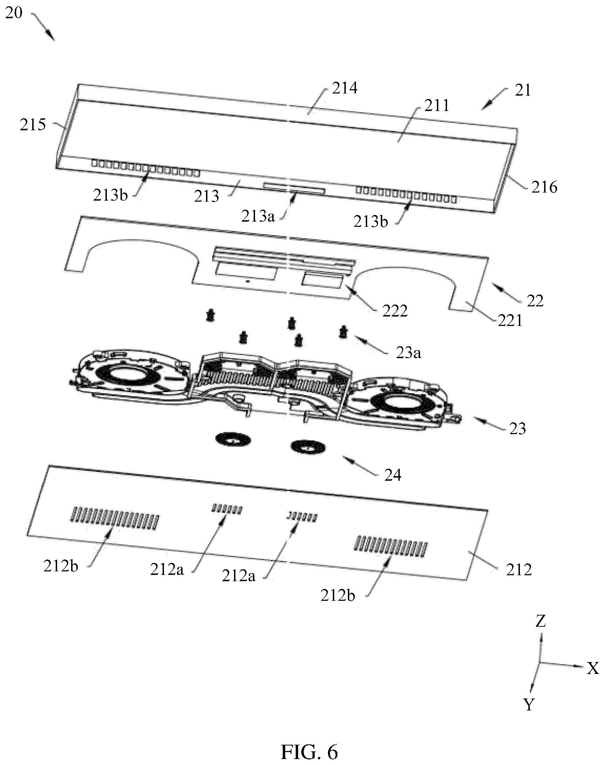

Reference is made to FIG. 5 and FIG. 6. FIG. 5 is an exploded view of the host 20 shown in FIG. 2. FIG. 6 is a schematic diagram of a structure existing when the exploded view shown in FIG. 5 is viewed from bottom to top. The host 20 further includes a circuit board assembly 22 disposed in the host housing 21.

The circuit board assembly 22 is located between the first wall plate 211 and the second wall plate 212. The circuit board assembly 22 includes a circuit board 221 and at least one heat generation device 222.

The circuit board 221 may be a rigid circuit board, a flexible circuit board, or a rigid-flexible circuit board. The circuit board 221 may be an FR-4 dielectric board, a Rogers (Rogers) dielectric board, an FR-4 and Rogers mixed dielectric board, or the like.

The at least one heat generation device 222 is disposed on the circuit board 221. Specifically, the at least one heat generation device 222 may be all disposed on a surface that is of the circuit board 221 and that faces the first wall plate 211, or may be all disposed on a surface that is of the circuit board 221 and that faces the second wall plate 212, or a part of the at least one heat generation device may be disposed on a surface that is of the circuit board 221 and that faces the first wall plate 211, and another part of the at least one heat generation device may be disposed on a surface that is of the circuit board 221 and that faces the second wall plate 212. This is not specifically limited herein. In the embodiments shown in FIG. 5 and FIG. 6, the at least one heat generation device 222 is all disposed on the surface that is of the circuit board 221 and that faces the second wall plate 212.

The heat generation device 222 is an electronic component, and the electronic component includes but is not limited to a resistor, a capacitor, an inductor, a potentiometer, an electron tube, a heat sink, an electromechanical element, a connector, a semiconductor discrete device, an electro-acoustic device, a laser device, an electronic display device, a photoelectric device, a sensor, a power supply, a switch, a micro-special motor, an electronic transformer, a relay, a printed circuit board, an integrated circuit device, and the like.

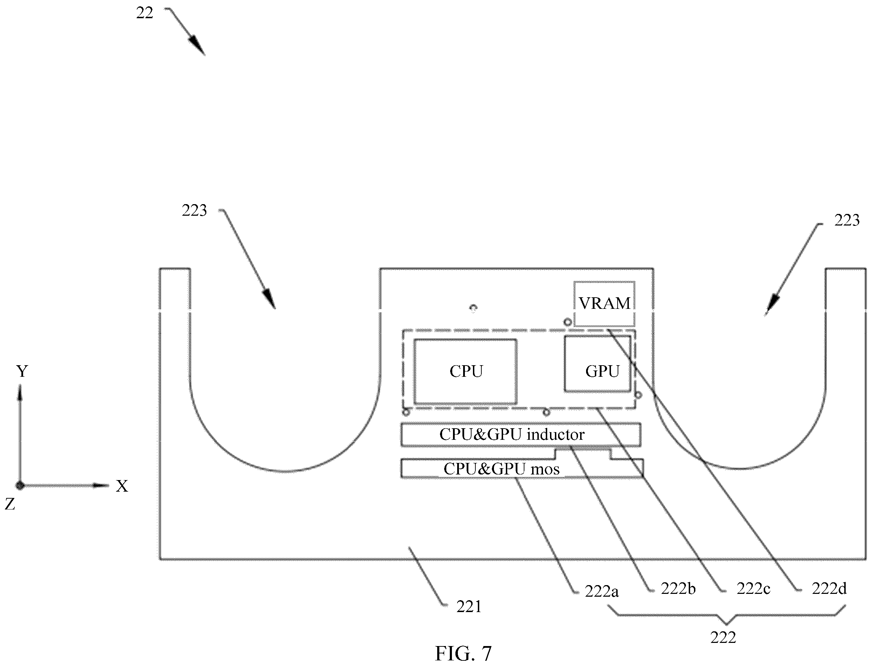

In some embodiments, reference is made to FIG. 7. FIG. 7 is a schematic diagram of a structure of a lower surface of a circuit board assembly 22 in the host 20 shown in FIG. 6. The at least one heat generation device 222 includes a first group of heat generation devices 222a, a second group of heat generation devices 222b, a third group of heat generation devices 222c, and a fourth group of heat generation devices 222d that are sequentially arranged from front to back in the Y-axis direction. In some embodiments, the first group of heat generation devices 222a includes a CPU mos transistor and a GPU mos transistor. The mos transistor is a metal (metal)-oxide (oxide)-semiconductor (semiconductor) field effect transistor, or is referred to as a metal-insulator (insulator)-semiconductor. The second group of heat generation devices 222b includes a CPU power supply inductor and a GPU power supply inductor. The third group of heat generation devices 222c includes a CPU and a CPU. The fourth group of heat generation devices 222d includes a VRAM. It should be noted that the first group of heat generation devices 222a, the second group of heat generation devices 222b, the third group of heat generation devices 222c, and the fourth group of heat generation devices 222d may be other electronic components. The at least one heat generation device 222 may alternatively include only one, two, or three of the first group of heat generation devices 222a, the second group of heat generation devices 222b, the third group of heat generation devices 222c, and the fourth group of heat generation devices 222d. This is not specifically limited herein.

The electronic component inevitably generates power consumption in a working process. The power consumption usually exists in a form of heat inside the electronic component or on a surface thereof, or is distributed to a surrounding region thereof. Accumulation of heat affects performance of the electronic component, and even burns out the electronic component. Therefore, the heat of the electronic component needs to be transferred to the outside of the host 20 by using a heat dissipation system.

To perform heat dissipation processing on the at least one heat generation device 222, in some embodiments, referring back to FIG. 5 and FIG. 6, the host 20 further includes a first heat dissipation system 23. The first heat dissipation system 23 is configured to force air outside the host 20 to enter the host 20 from the two second air inlet structures 212b on the second wall plate 212, and be discharged from the two second air outlet structures 213b on the third wall plate 213, to form a first airflow inside the host 20. In addition, heat of the at least one heat generation device 222 is transferred to a path of the first airflow, so that the heat is transferred to the outside of the host 20 by using the first airflow.

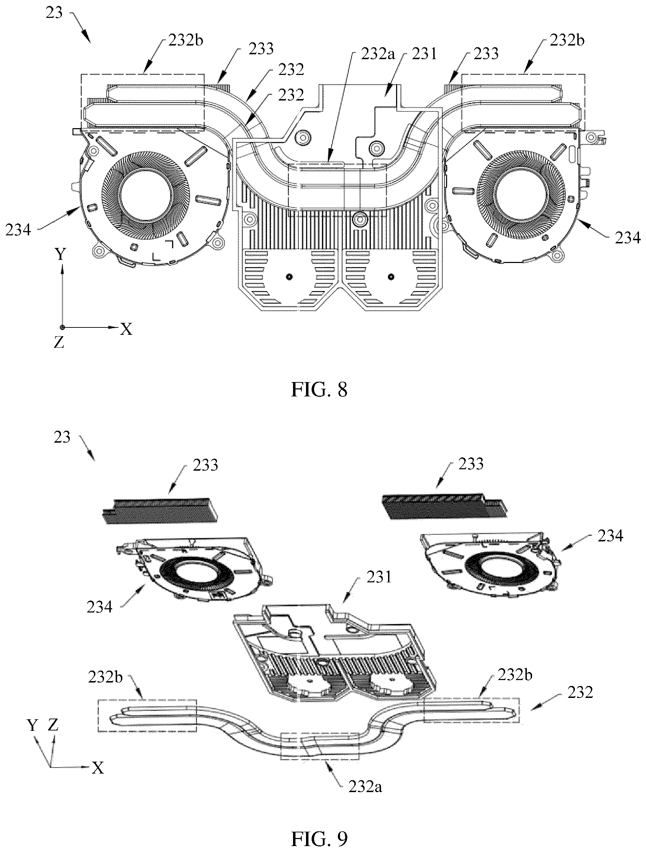

Reference is made to FIG. 8 and FIG. 9. FIG. 8 is a schematic diagram of a structure existing when a first heat dissipation system 23 in the host 20 shown in FIG. 5 is viewed from bottom to top. FIG. 9 is an exploded view of the first heat dissipation system 23 shown in FIG. 8. The first heat dissipation system 23 includes a heat dissipation plate 231, at least one heat pipe 232, at least one group of fins 233, and at least one first fan 234.

The heat dissipation plate 231 is disposed between the circuit board assembly 22 and the second wall plate 212. In some embodiments, the circuit board 221 in the circuit board assembly 22 and the heat dissipation plate 231 are stacked and spaced apart from each other, and the heat dissipation plate 231 and the second wall plate 212 are stacked and spaced apart from each other. In some embodiments, the heat dissipation plate 231 is fastened to the circuit board assembly 22. Optionally, referring back to FIG. 5 and FIG. 6, the heat dissipation plate 231 is fastened to the circuit board 221 of the circuit board assembly 22 by using at least one spring screw 23a. There may be one or more spring screws 23a. In the embodiments shown in FIG. 5 and FIG. 6, there are five spring screws 23a. In some other embodiments, the heat dissipation plate 231 may be fastened to the circuit board 221 of the circuit board assembly 22 by using a structure such as a common screw or a clamping buckle.

The heat dissipation plate 231 is thermally conductive with the at least one heat generation device 222, that is, there is a thermal conduction path between the heat dissipation plate 231 and the at least one heat generation device 222, so that the heat of the at least one heat generation device 222 can be transferred to the heat dissipation plate 231 along the thermal conduction path.

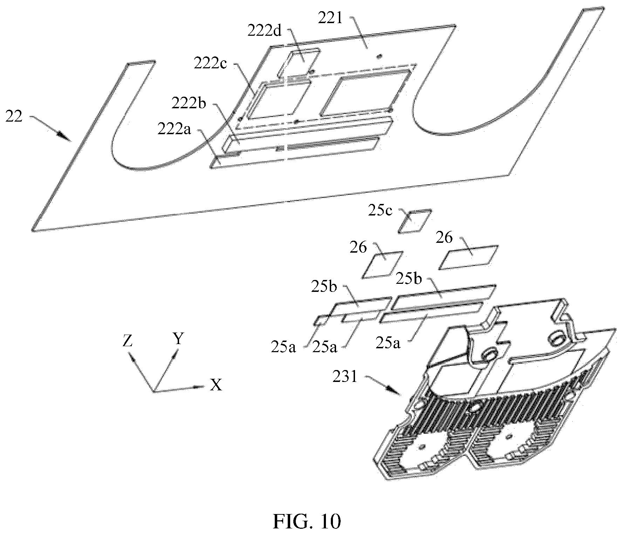

In some embodiments, reference is made to FIG. 10. FIG. 10 is an exploded view of a heat dissipation plate 231 in the first heat dissipation system 23 shown in FIG. 9 and a circuit board assembly 22. A thermally conductive pad 25a is disposed between the heat dissipation plate 231 and the first group of heat generation devices 222a, a heat thermally conductive pad 25b is disposed between the heat dissipation plate 231 and the second group of heat generation devices 222b, and a thermally conductive pad 25c is disposed between the heat dissipation plate 231 and the fourth group of heat generation devices 222d. Materials of the thermally conductive pad 25a, the thermally conductive pad 25b, and the thermally conductive pad 25c have thermally conductive performance, and are soft and elastic to some extent. Specifically, the materials of the thermally conductive pad 25a, the thermally conductive pad 25b, and the thermally conductive pad 25c include but are not limited to silica gel and foam. The thermally conductive pad 25a, the thermally conductive pad 25b, and the thermally conductive pad 25c are respectively used to fill a design gap between the heat dissipation plate 231 and each of the first group of heat generation devices 222a, the second group of heat generation devices 222b, and the fourth group of heat generation devices 222d, so that heat generated by the first group of heat generation devices 222a, the second group of heat generation devices 222b, and the fourth group of heat generation devices 222d can be quickly transferred to the heat dissipation plate 231 respectively along the thermally conductive pad 25a, the thermally conductive pad 25b, and the thermally conductive pad 25c.

In some embodiments, still referring to FIG. 10, a thermally conductive paste 26 is disposed between the heat dissipation plate 231 and the third group of heat generation devices 222c. A material of the thermally conductive paste 26 includes but is not limited to thermally conductive gel and thermally conductive silicone. In an assembly process, the thermally conductive paste 26 is in a shape of a paste, and can fill an assembly gap between the heat dissipation plate 231 and the third group of heat generation devices 222c, to reduce thermal contact resistance between the heat dissipation plate 231 and each of the CPU and the GPU of the third group of heat generation devices 222c.

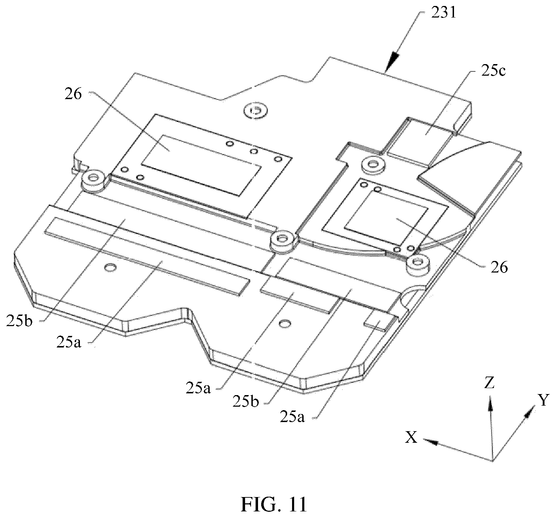

Reference is made to FIG. 11. FIG. 11 is a schematic diagram of positions of a thermally conductive pad and a thermally conductive paste on the heat dissipation plate 231 in FIG. 10.

In some other embodiments, the gap between the heat dissipation plate 231 and each of the first group of heat generation devices 222a, the second group of heat generation devices 222b, and the fourth group of heat generation devices 222d may be filled with a thermally conductive paste, and the gap between the heat dissipation plate 231 and the third group of heat generation devices 222c may be filled with a thermally conductive pad. This is not specifically limited in this application.

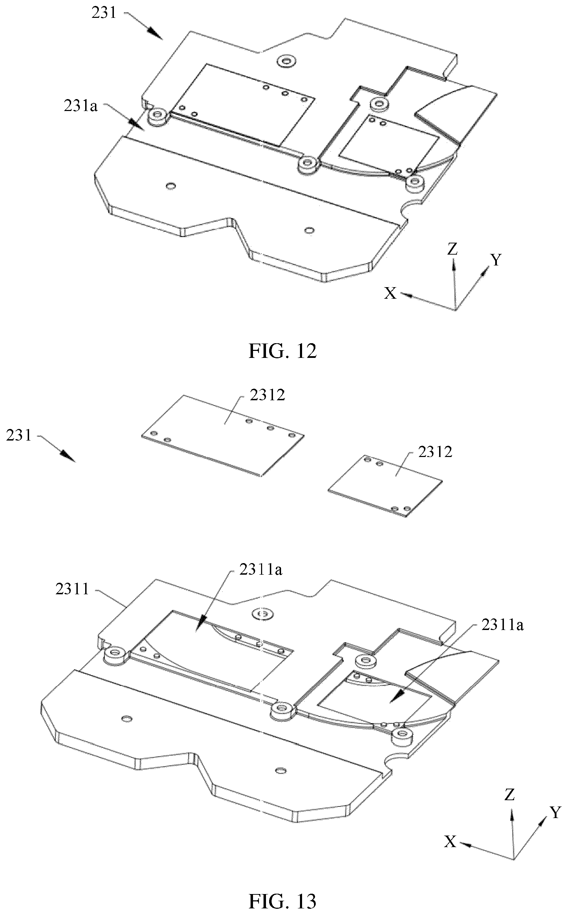

A surface that is of the heat dissipation plate 231 and on which the thermally conductive pad and the thermally conductive paste are disposed is opposite to the circuit board assembly 22, and the surface may be a flat surface, or may be an uneven surface. However, heights of electronic components that are in the circuit board assembly 22 and that protrude from a surface of the circuit board 221 are generally inconsistent. For example, heights of the CPU power supply inductor and the GPU power supply inductor that protrude from the circuit board 221 are larger than those of the CPU, the CPU, the CPU mos transistor, the GPU mos transistor, and the VRAM. On this basis, to be compatible with a surface of the circuit board assembly 22, optionally, reference is made to FIG. 12. FIG. 12 is a schematic diagram of a structure of a surface that is of the heat dissipation plate 231 in FIG. 11 and on which a thermally conductive pad and a thermally conductive paste are disposed. The surface that is of the heat dissipation plate 231 and on which the thermally conductive pad and the thermally conductive paste are disposed is an uneven surface. A concave part on the surface is used to accommodate an electronic component whose protrusion height is large in the circuit board assembly 22, for example, a concave part 231a is used to accommodate the CPU power supply inductor and the GPU power supply inductor whose protrusion heights are large. In this way, the design gap between the heat generation device in the circuit board assembly 22 and the heat dissipation plate 231 may be reduced, to reduce a quantity of thermally conductive pastes and a thickness of the thermally conductive pad, shorten the thermally conductive path, and improve thermally conductive efficiency.

It should be noted that, when the heat generation device 222 is disposed on a surface that is of the circuit board 221 and that faces away from the heat dissipation plate 231, the heat dissipation plate 231 and the heat generation device 222 are separated from each other by the circuit board 221, and the heat dissipation plate 231 and the heat generation device 222 are thermally conductive at least by using the circuit board 221. Specifically, the heat of the heat generation device 222 is first transferred to a region that is on the circuit board 221 and in which the heat generation device 222 is located. Further, the heat dissipation plate 231 may be thermally conductive with, through direct contact or by using an intermediate medium layer, the region that is on the circuit board 221 and in which the heat generation device 222 is located, to further directly transfer, to the heat dissipation plate 231, the heat transferred to the circuit board 221, or transfer the heat to the heat dissipation plate 231 by using the intermediate medium layer.

The heat dissipation plate 231 has good thermally conductive performance. A material of the heat dissipation plate 231 includes but is not limited to metal such as copper, iron, aluminum, a copper alloy, an iron alloy, an aluminum alloy, and magnalium, and non-metal with good thermally conductive performance such as graphite and diamond.

The heat dissipation plate 231 may be an integral structural member, or may be formed by assembling a plurality of parts. To reduce molding difficulty of the heat dissipation plate 231 with an uneven surface, the heat dissipation plate 231 may be molded into an integral structural member by using a material with low molding difficulty such as aluminum, an aluminum alloy, and magnalium. However, a thermal conductivity of the material such as aluminum, an aluminum alloy, and magnalium is lower than a thermal conductivity of a material such as copper, a copper alloy, and graphite, and a heat dissipation effect of the material such as aluminum, an aluminum alloy, and magnalium is poorer. To improve heat dissipation performance of the heat dissipation plate 231, the heat dissipation plate 231 may be molded into an integral structural member by using the material such as copper, a copper alloy, and graphite. However, it is difficult for the material such as copper, a copper alloy, and graphite to be molded into an uneven surface.

To consider both heat dissipation performance and molding difficulty of the heat dissipation plate 231, in some embodiments, reference is made to FIG. 13. FIG. 13 is an exploded view of the heat dissipation plate 231 shown in FIG. 12. The heat dissipation plate 231 includes a heat dissipation plate body 2311 and a thermally conductive insert 2312. An opening 2311a is disposed at a position that is on the heat dissipation plate body 2311 and that is opposite to the heat generation device 222. The thermally conductive insert 2312 is disposed in the opening 2311a, the heat generation device 222 is thermally conductive with the thermally conductive insert 2312, and an edge of the thermally conductive insert 2312 is thermally conductive with an edge of the heat dissipation plate body 2311 at the opening 2311a.

In the foregoing embodiment, the opening 2311a may be disposed at positions that are on the heat dissipation plate body 2311 and that are opposite to some heat generation devices 222, or the opening 2311a may be disposed at a position corresponding to each heat generation device 222.

In some embodiments, referring to FIG. 13, the opening 2311a is disposed at a position that is on the heat dissipation plate body 2311 and that is opposite to the third group of heat generation devices 222c. Specifically, there are two openings 2311a, and the two openings 2311a are respectively disposed at positions that are on the heat dissipation plate body 2311 and that are opposite to the CPU and the CPU in the third group of heat generation devices 222c. On this basis, there are also two thermally conductive inserts 2312. The two thermally conductive inserts 2312 are respectively disposed in the two openings 2311a, and the two thermally conductive inserts 2312 are thermally conductive with edges of the heat dissipation plate body 2311 at the two openings 2311a. In some other embodiments, the opening 2311a may be disposed at a position that is on the heat dissipation plate body 2311 and that is opposite to the first group of heat generation devices 222a, the second group of heat generation devices 222b, or the fourth group of heat generation devices 222d, and the thermally conductive insert 2312 is disposed in the opening 2311a. This is not specifically limited herein.

In this way, the heat dissipation plate body 2311 and the thermally conductive insert 2312 may be molded by using different materials, to consider both heat dissipation performance and structural molding difficulty of the heat dissipation plate 231. Specifically, the heat dissipation plate body 2311 may be made of a structure with low molding difficulty such as aluminum, an aluminum alloy, and magnalium, and the thermally conductive insert 2312 may be made of a material with a high thermal conductivity such as copper, a copper alloy, and graphite, to consider both heat dissipation performance and structural molding difficulty of the heat dissipation plate 231.

Referring back to FIG. 8 and FIG. 9, the heat pipe 232 may include a pipe housing, and a wick and a working fluid that are disposed in the pipe housing. The pipe housing has good thermally conductive performance, and a material of the pipe housing includes but is not limited to metal such as copper, iron, aluminum, a copper alloy, an iron alloy, an aluminum alloy, and magnalium, and non-metal with good thermally conductive performance such as graphite and diamond. The wick is a capillary porous material. A single heat pipe 232 may include an evaporation section (also referred to as a heating section) 232a and at least one condensation section (also referred to as a cooling section) 232b.

The evaporation section 232a is located on a side that is of the heat dissipation plate 231 and that is away from the circuit board assembly 22, and the evaporation section 232a is thermally conductive with the heat dissipation plate 231. In some embodiments, the evaporation section 232a may be welded to the heat dissipation plate 231 to be thermally conductive with the heat dissipation plate 231 by using a welding material. In some other embodiments, the evaporation section 232a and the heat dissipation plate 231 may be thermally conductive with each other through direct contact or by using an intermediate medium layer such as a thermally conductive paste and a thermally conductive pad.

In some embodiments, an orthogonal projection of the evaporation section 232a on the heat dissipation plate 231 overlaps an orthogonal projection of the third group of heat generation devices 222c on the heat dissipation plate 231. The orthogonal projection of the evaporation section 232a on the heat dissipation plate 231 is a projection of the evaporation section 232a on the heat dissipation plate 231 in the Z-axis direction. The orthogonal projection of the third group of heat generation devices 222c on the heat dissipation plate 231 is a projection of the third group of heat generation devices 222c on the heat dissipation plate 231 in the Z-axis direction. The evaporation section 232a is welded to the heat dissipation plate body 2311 and the thermally conductive insert 2312 of the heat dissipation plate 231. In this way, a heat transfer path between the evaporation section 232a and the third group of heat generation devices 222c is short, so that heat dissipation efficiency of the third group of heat generation devices 222c is high. In some other embodiments, the orthogonal projection of the evaporation section 232a on the heat dissipation plate 231 may overlap orthogonal projections of the first group of heat generation devices 222a, the second group of heat generation devices 222b, and the fourth group of heat generation devices 222d on the heat dissipation plate 231.

Heat of the heat dissipation plate 231 may be transferred to the evaporation section 232a of the heat pipe 232, so that liquid in the wick in the evaporation section 232a evaporates and vaporizes. When the vapor flows to the condensation section 232b under a small pressure difference, the vapor releases heat and condenses into liquid, and then the liquid flows back to the evaporation section 232a along the porous material under the action of capillary force. This cycle repeats, so that the heat can be transferred from the evaporation section 232a to the condensation section 232b.

On a single heat pipe 232, there may be one or two condensation sections 232b. In the embodiments shown in FIG. 8 and FIG. 9, there are two condensation sections 232b, and the two condensation sections 232b are respectively connected to two ends of the evaporation section 232a in a length direction.

There may be one or more heat pipes 232. For example, referring to FIG. 8 and FIG. 9, there are two heat pipes 232. Evaporation sections 232a of the two heat pipes 232 are located on the side that is of the heat dissipation plate 231 and that is away from the circuit board assembly 22, and are thermally conductive with the heat dissipation plate 231.

The fin 233 is disposed outside the condensation section 232b of the heat pipe 232, and is thermally conductive with a pipe housing of the condensation section 232b. Specifically, the fin 233 may be fastened outside the pipe housing of the condensation section 232b through welding or integral molding, to be thermally conductive with the pipe housing of the condensation section 232b by using a welding material. The fin 233 is configured to increase a heat exchange area between the condensation section 232b and an external environment, to improve heat exchange efficiency. One or more groups of fins 233 may be disposed. In the embodiments shown in FIG. 8 and FIG. 9, there are two groups of fins 233, one group of fins 233 in the two groups of fins 233 is disposed outside one condensation section 232b of the two heat pipes 232, and the other group of fins 233 is disposed outside the other condensation section 232b of the two heat pipes 232.

The first fan 234 is configured to force air outside the host 20 to enter the host 20 from the two second air inlet structures 212b on the second wall plate 212, and be discharged from the two second air outlet structures 213b on the third wall plate 213, to form a first airflow inside the host 20. In some embodiments, the first fan 234 may be a centrifugal fan, and an axial direction of the first fan 234 is approximately perpendicular to the circuit board 221, the heat dissipation plate 231, and the second wall plate 212. A size of the centrifugal fan in the axial direction is small, and an occupation height thereof in the host housing 21 is small. This facilitates thinning of the host 20. On this basis, optionally, there are two first fans 234. The two first fans 234 are arranged at intervals. Optionally, an arrangement direction of the two first fans 234 is parallel to the second wall plate 212. Optionally, the arrangement direction of the two first fans 234 is further parallel to the third wall plate 213. Each first fan 234 has an air inlet and an air outlet, the air inlets of the two first fans 234 respectively communicate with the two second air inlet structures 212b on the second wall plate 212, and the air outlets of the two first fans 234 respectively communicate with the two second air outlet structures 213b on the third wall plate 213. The foregoing two groups of fins 233 are respectively located on air outlet sides of the two first fans 234, and the air outlet side is a side that the air outlet faces. Specifically, the fin 233 is located on an airflow channel between the air outlet of the first fan 234 and the second air outlet structure 213b, and the two groups of fins 233 are respectively located on airflow channels between the two first fans 234 and the corresponding second air outlet structures 213b. Therefore, through forced convection heat exchange, the working fluid in the condensation section 232b is accelerated to release heat to condense into liquid.

In some other embodiments, the first fan 234 may alternatively be an axial-flow fan, a cross-flow fan, or the like. This is not specifically limited herein.

In some embodiments, referring back to FIG. 7, an avoidance notch 223 is disposed at a position that is on the circuit board 221 and that corresponds to the first fan 234, and the avoidance notch 223 is used to avoid the first fan 234, to prevent the circuit board 221 from limiting a height of the first fan 234, so that a first fan 234 with a higher power can be selected to improve heat dissipation efficiency of the first heat dissipation system 23.

Based on the descriptions in the foregoing embodiments, a heat transfer path of the first heat dissipation system 23 is as follows: heat generation device 222 → heat dissipation plate 231 → heat pipe 232 → fin 233 → first airflow generated by the first fan 234. The heat dissipation path is long, and is affected by factors such as thermal resistance of a connection part between the heat dissipation plate 231 and the heat generation device 222, thermal resistance of the heat dissipation plate 231, thermal resistance of the heat pipe 232, thermal resistance of a welding part between the heat pipe 232 and the fin 233, a heat dissipation area of the fin 233, and performance of the first fan 234. As a result, heat dissipation efficiency is low, and heat cannot be effectively exchanged with the outside. Consequently, surface temperature of the entire computer is excessively high, and performance and user experience thereof are low.

To improve heat dissipation efficiency, the heat dissipation path may be shortened. Specifically, referring back to FIG. 5 and FIG. 6, the host 20 further includes a second heat dissipation system 24. The second heat dissipation system 24 is configured to force air outside the host 20 to enter the host 20 from the two first air inlet structures 212a on the second wall plate 212, and be discharged from the first air outlet structure 213a on the third wall plate 213, to form a second airflow inside the host 20. Heat generated by the heat generation device 222 may be transferred to the outside of the host 20 by using the second airflow.

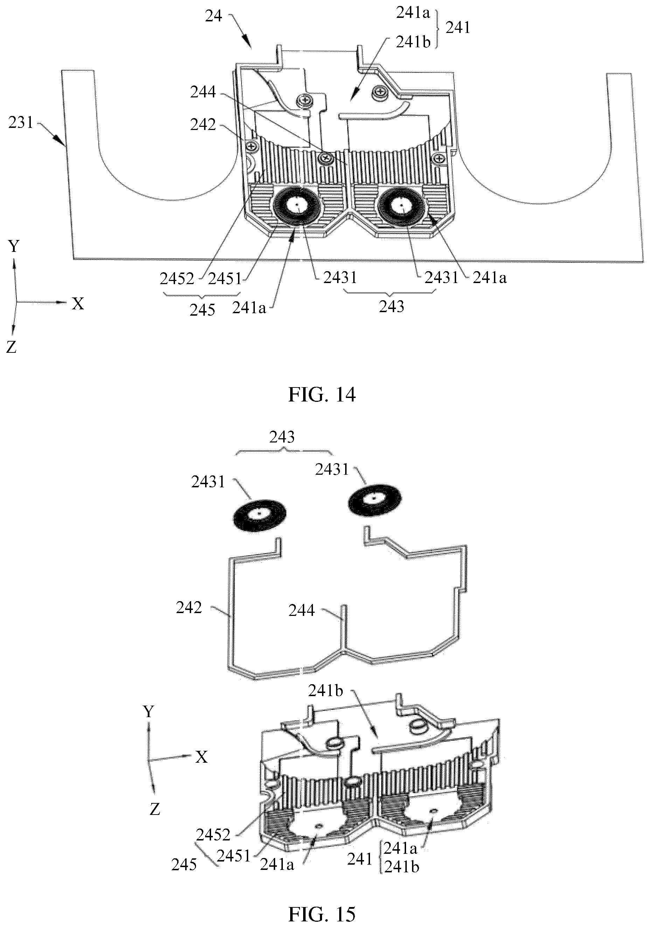

Specifically, reference is made to FIG. 14 and FIG. 15. FIG. 14 is a schematic diagram of an assembly structure of a second heat dissipation system 24 and a circuit board assembly 22 in the host 20 shown in FIG. 5 and FIG. 6. FIG. 15 is an exploded view of the second heat dissipation system 24 in the assembly diagram shown in FIG. 14. The second heat dissipation system 24 includes a second fan 243. The second fan 243 is disposed in the host housing 21, and is located between the foregoing two first fans 234. The second fan 243 has an air inlet and an air outlet. The air inlet of the second fan 243 communicates with the at least one first air inlet structure 212a. The air outlet of the second fan 243 communicates with the first air outlet structure 213a. It should be noted that, when the second fan 243 is located between the two first fans 234, a projection of an axis of the second fan 243 on the third wall plate is located between projections of axes of the two first fans 234 on the third wall plate. The second fan 243 may or may not be on a same straight line as the two first fans 234.

In this way, the foregoing first heat dissipation system 23 can take away a part of heat inside the host 20. In addition, when the second fan 243 runs, air outside the host 20 enters the host 20 from the two first air inlet structures 212a, and is discharged from the first air outlet structure 213a. Therefore, another part of heat in the host 20 can be taken away, thereby improving heat dissipation efficiency of the host.

On the basis of the foregoing embodiment, optionally, the second heat dissipation system 24 further includes the foregoing heat dissipation plate 231. The second fan 243 includes at least one fan body 2431 and a fan housing. The at least one fan body 2431 is located on the side that is of the heat dissipation plate 231 and that is away from the circuit board assembly 22, that is, the at least one fan body 2431 is located between the heat dissipation plate 231 and the second wall plate 212. The fan housing covers the outside of the at least one fan body 2431, and the heat dissipation plate 231 forms one wall plate of the fan housing.

In this way, after heat generated by the heat generation device 222 is transferred to the heat dissipation plate 231, the heat can be directly exchanged with an airflow in an internal space 241 of the fan housing, and is further brought out to the outside of the host 20 by the first air outlet structure 213a. A heat transfer path of the second heat dissipation system 24 is as follows: heat generation device 222 → heat dissipation plate 231 → airflow in the internal space 241 of the fan housing. Compared with the foregoing first heat dissipation system 23, the heat transfer path of the second heat dissipation system 24 is shorter, and heat dissipation efficiency is higher. Therefore, this can avoid excessively high surface temperature of the entire computer, and improve performance and user experience of the entire computer.

In addition, because the heat dissipation plate 231 forms one wall plate of the fan housing, heights of the fan housing of the second fan 243 and the heat dissipation plate 231 are prevented from being superposed in the thickness direction (namely, the Z-axis direction) of the host 20, to facilitate thinning of a thickness of the host 20. In another aspect, a space between the heat dissipation plate 231 and the second wall plate 212 is narrow when the thickness of the host 20 is fixed. On this basis, because the heat dissipation plate 231 forms one wall plate of the fan housing of the second fan 243, it is convenient to mount the second fan 243 in the narrow space between the heat dissipation plate 231 and the second wall plate 212.

On the basis of the foregoing embodiment, optionally, the second wall plate 212 forms another wall plate that is of the fan housing and that is opposite to the heat dissipation plate 231. In this way, heights of the fan housing and the second wall plate 212 can be prevented from being superposed in the Z-axis direction, to facilitate thinning of the thickness of the host 20. In another aspect, it is convenient to mount the second fan 243 in the narrow space between the heat dissipation plate 231 and the second wall plate 212.

In some embodiments, still referring to FIG. 14 and FIG. 15, the second heat dissipation system 24 further includes an air baffle strip 242. The air baffle strip 242 is disposed between the heat dissipation plate 231 and the second wall plate 212, and surrounds the at least one fan body 2431. The air baffle strip 242 forms a side wall of the fan housing, and surrounds the internal space 241 of the fan housing with the heat dissipation plate 231 and the second wall plate 212. In this way, it is convenient to concentrate airflows, to ensure heat dissipation efficiency. A position of the air baffle strip 242 may be set based on a requirement, to prevent the airflow in the fan housing and another airflow (for example, the airflow generated by the first fan 234) in the host 20 from affecting each other.

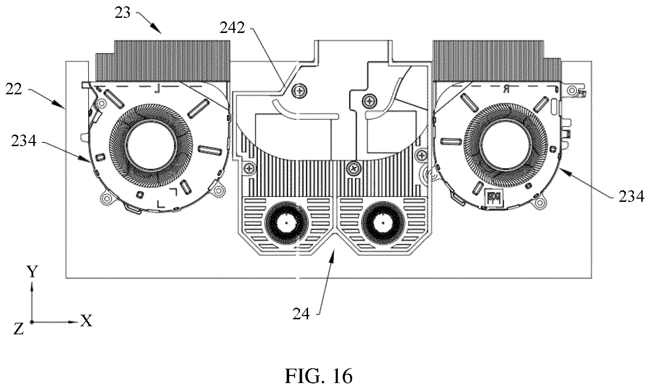

In some embodiments, reference is made to FIG. 16. FIG. 16 is an assembly diagram of the second heat dissipation system 24, the circuit board assembly 22, and the first heat dissipation system 23 shown in FIG. 14. The air baffle strip 242 is disposed between the two first fans 234 of the first heat dissipation system 23. In this way, the airflow in the fan housing can be prevented from flowing back to affect air intake efficiency of the first fan 234.

A material of the air baffle strip 242 may be a rigid material, or may be a soft elastic material. The soft elastic material includes but is not limited to foam and silica gel. In some embodiments, the material of the air baffle strip 242 is a soft elastic material, so that a gap between the heat dissipation plate 231 and the second wall plate 212 can be effectively sealed, and a specific assembly error can be compensated for.

In some other embodiments, the air baffle strip 242 may not be disposed, and the side wall of the fan housing is formed by using the wall plate of the host housing 21. This is not specifically limited herein.

In the foregoing embodiment, the fan body 2431 includes a central shaft and a plurality of blades disposed around the central shaft. When the fan body 2431 runs, air outside the host 20 may be forced to enter the internal space 241 of the fan housing from the two first air inlet structures 212a, and be discharged from the first air outlet structure 213a. In some embodiments, still referring to FIG. 14 and FIG. 15, the central shaft of the at least one fan body 2431 is approximately perpendicular to the heat dissipation plate 231 and the second wall plate 212, and the blade of the at least one fan body 2431 is a centrifugal blade. In this way, the second fan 243 is a centrifugal fan, and a size of the centrifugal fan in an axial direction of the centrifugal fan is small, to facilitate mounting in the narrow space between the heat dissipation plate 231 and the second wall plate 212.

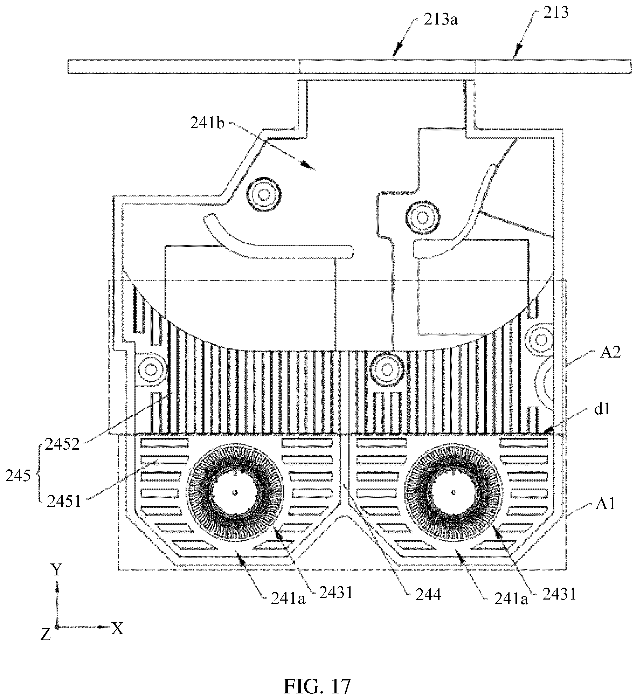

There may be one or more fan bodies 2431 in the second fan 243. When there are a plurality of fan bodies 2431, the plurality of fan bodies 2431 may be arranged at intervals in a direction (namely, the X-axis direction) parallel to the third wall plate 213. For example, reference is made to FIG. 17. FIG. 17 is a front view of the second heat dissipation system 24 in the assembly structure shown in FIG. 14 and a third wall plate 213 of a host housing. There are two fan bodies 2431, and the two fan bodies 2431 are arranged at intervals in the X-axis direction. In some other embodiments, there may alternatively be three or four fan bodies 2431.

In this way, an air volume of the second heat dissipation system 24 can be increased. In addition, distances from the plurality of fan bodies 2431 to the first air outlet structure 213a on the third wall plate 213 are approximately equal, so that airflows generated by the plurality of fan bodies 2431 can be prevented from affecting each other.

On the basis of the foregoing embodiment, to further reduce a possibility that the airflows generated by the plurality of fan bodies 2431 affect each other, in some embodiments, still referring to FIG. 17, a separator 244 is disposed between two adjacent fan bodies 2431. The separator 244 separates the internal space 241 of the fan housing into a plurality of sub-spaces 241a, and the plurality of fan bodies 2431 are respectively located in the plurality of sub-spaces 241a. The air duct 241 further includes a main space 241b located between the plurality of sub-spaces 241a and the first air outlet structure 213a, the plurality of sub-spaces 241a communicate with the main space 241b, and the main space 241b communicates with the first air outlet structure 213a. In this way, the airflow generated by the fan body 2431 enters the main space 241b along the plurality of sub-spaces 241a, and is further discharged from the first air outlet structure 213a through the main space 241b. The separator 244 can prevent airflows generated by the two adjacent fan bodies 2431 from affecting each other.

In the foregoing embodiment, a material of the separator 244 may be a rigid material, or may be a soft elastic material. The soft elastic material includes but is not limited to foam and silica gel. In some embodiments, the material of the separator 244 is a soft elastic material, so that a gap between the heat dissipation plate 231 and the second wall plate 212 can be blocked in the Z-axis direction, and a specific assembly error can be compensated for. On this basis, in some embodiments, referring to FIG. 15, the separator 244 is connected to the air baffle strip 242, the material of the separator 244 is the same as the material of the air baffle strip 242, and the separator 244 and the air baffle strip 242 are formed integrally. In this way, complexity of a composition structure of the host 20 can be reduced, and assembly difficulty thereof can be reduced.

To further improve heat dissipation efficiency of the second heat dissipation system 24, in some embodiments, referring to FIG. 14, FIG. 15, and FIG. 17, the second heat dissipation system 24 further includes a heat dissipation fin 245. The heat dissipation fin 245 is disposed on a surface that is of the heat dissipation plate 231 and that is away from the circuit board assembly 22, and the heat dissipation fin 245 is located in the internal space 241 of the fan housing. In this way, a heat exchange area between the heat dissipation plate 231 and the airflow in the fan housing can be increased by using the heat dissipation fin 245, thereby improving heat dissipation efficiency.

In the foregoing embodiment, the heat dissipation fin 245 may be welded and fastened to the surface that is of the heat dissipation plate 231 and that is away from the circuit board assembly 22, or may be integrally formed with the heat dissipation plate 231, that is, the heat dissipation fin 245 and the heat dissipation plate 231 are an integral structural member. In this way, structural complexity of the second heat dissipation system 24 can be reduced, and assembly difficulty thereof can be reduced.

In some embodiments, there are a plurality of heat dissipation fins 245, the plurality of heat dissipation fins 245 form at least one heat dissipation fin group, and a quantity of the at least one heat dissipation fin group is equal to a quantity of the at least one fan body 2431 and the at least one heat dissipation fin group is in a one-to-one correspondence with the at least one fan body.

For example, still referring to FIG. 14, FIG. 15, and FIG. 17, there are a plurality of heat dissipation fins 245, the plurality of heat dissipation fins 245 form two heat dissipation fin groups, a quantity of the two heat dissipation fin groups is equal to a quantity of the two fan bodies 2431 and the two heat dissipation fin groups are in a one-to-one correspondence with the two fan bodies, and the two heat dissipation fin groups are respectively disposed in sub-spaces 241a in which the two fan bodies 2431 are located.

On the foregoing basis, optionally, the fan body 2431 has a first side and a second side that are opposite to each other. It should be noted that both the first side and the second side refer to spaces on two opposite sides of the fan body 2431. An arrangement direction of the first side, the fan body 2431, and the second side is parallel to the third wall plate 213 of the host housing 21, that is, the first side, the fan body 2431, and the second side are arranged in the X-axis direction. On this basis, referring to FIG. 17, the heat dissipation fin group corresponding to the fan body 2431 includes two rows of first heat dissipation fins 2451, and the two rows of first heat dissipation fins 2451 are respectively located on the first side and the second side of the fan body 2431. Each row of first heat dissipation fins 2451 includes a plurality of first heat dissipation fins 2451, the plurality of first heat dissipation fins 2451 are arranged at intervals in a direction (namely, the Y-axis direction) perpendicular to the third wall plate 213, and each first heat dissipation fin 2451 extends in the direction (namely, the X-axis direction) parallel to the third wall plate 213.

In this way, the first heat dissipation fins 2451 are located on two opposite sides of the fan body 2431, and an airflow generated by the fan body 2431 through rotation may enter a gap between two adjacent first heat dissipation fins 2451, to fully exchange heat with the first heat dissipation fins 2451, thereby improving heat exchange efficiency. In addition, extension directions of the first heat dissipation fins 2451 in the two rows of first heat dissipation fins 2451 are the same, so that a structure is simple, and processing costs are low.

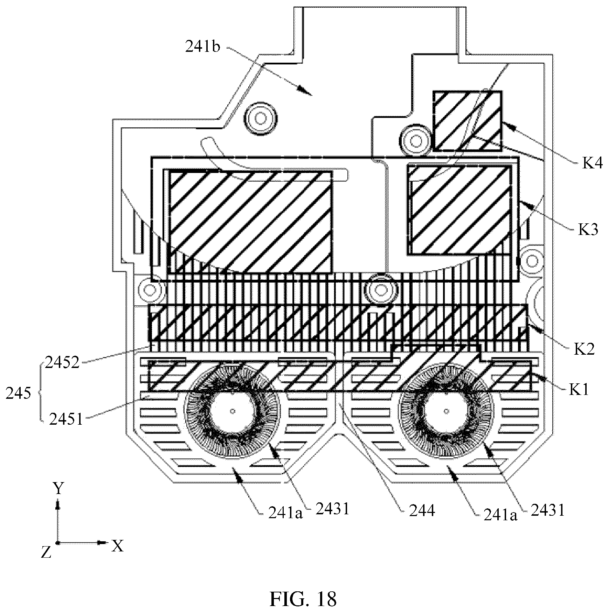

On the basis of the foregoing embodiment, referring to FIG. 17, it is assumed that an occupation region, on the heat dissipation plate 231, of the at least one fan body 2431 and the two rows of first heat dissipation fins 2451 in the heat dissipation fin group respectively corresponding to the at least one fan body 2431 is a first region A1. On this basis, reference is made to FIG. 18. FIG. 18 is a schematic diagram of a projection, on a heat dissipation plate 231, of a heat generation device 222 in the host 20 shown in FIG. 6. In the heat generation device 222, an orthogonal projection of the first group of the heat generation devices 222a on the heat dissipation plate 231 is a first projection K1. The orthogonal projection of the first group of heat generation devices 222a on the heat dissipation plate 231 is a projection of the first group of heat generation devices 222a on the heat dissipation plate 231 in the Z-axis direction. The first projection K1 overlaps the first region A1. In this way, a heat dissipation distance between the first group of heat generation devices 222a and each of the at least one fan body 2431 and the first heat dissipation fin 2451 is close, so that heat dissipation efficiency of the first group of heat generation devices 222a can be improved.

On the basis of the foregoing embodiment, optionally, still referring to FIG. 17, the heat dissipation fin group corresponding to the fan body 2431 further includes a plurality of second heat dissipation fins 2452. The plurality of second heat dissipation fins 2452 are located between the fan body 2431 and the first air outlet structure 213a, the plurality of second heat dissipation fins 2452 are arranged at intervals in the direction (namely, the X-axis direction) parallel to the third wall plate 213, and each second heat dissipation fin 2452 extends in the direction perpendicular to the third wall plate 213. In this way, an airflow that flows from the fan body 2431 to the first air outlet structure 213a may pass through the plurality of second heat dissipation fins 2452, so that heat exchange efficiency can be further improved.

In some embodiments, the plurality of second heat dissipation fins 2452 are further located between the two rows of first heat dissipation fins 2451 and the first air outlet structure 213a, and the plurality of second heat dissipation fins 2452 are spaced apart from the two rows of first heat dissipation fins 2451. In this way, there is a first gap d1 between the plurality of second heat dissipation fins 2452 and the two rows of first heat dissipation fins 2451. The airflow generated by the fan body 2431 may flow in a length direction of the first gap d1, and enter a gap between two adjacent second heat dissipation fins 2452 from the first gap d1, so that the airflow can pass through gaps between the plurality of second heat dissipation fins 2452, to improve heat exchange efficiency.

In some other embodiments, it is assumed that a surface that is of the heat dissipation plate 231 and that faces the circuit board assembly 22 is a first surface, and a surface that is of the heat dissipation plate 231 and that faces the internal space 241 of the fan housing is a second surface. Based on the foregoing descriptions, the first surface is an uneven surface. On this basis, referring back to FIG. 15, the second surface may also be an uneven surface. Specifically, a concave part is formed at a position that is on the second surface and that is opposite to a convex part on the first surface, and a convex part is formed at a position that is on the second surface and that is opposite to a concave part on the first surface. In this way, thicknesses of all parts on the heat dissipation plate 231 are approximately uniform, so that both structural strength and material costs can be considered. On this basis, a region that is on the second surface and on which the plurality of second heat dissipation fins 2452 are disposed and a region that is on the second surface and on which the two rows of first heat dissipation fins 2451 are disposed have a height difference in the Z-axis direction. Specifically, the region that is on the second surface and on which the plurality of second heat dissipation fins 2452 are disposed is the convex part on the second surface, and the region that is on the second surface and on which the two rows of first heat dissipation fins 2451 are disposed is the concave part on the second surface. Based on the height difference, the airflow generated by the fan body 2431 may pass through a gap between any two adjacent second heat dissipation fins 2452 in the plurality of second heat dissipation fins 2452 without disposing the foregoing first gap d1 between the plurality of second heat dissipation fins 2452 and the two rows of first heat dissipation fins 2451, to improve heat exchange efficiency.

In some embodiments, still referring to FIG. 17, it is assumed that an occupation region, on the heat dissipation plate 231, of the plurality of second heat dissipation fins 2452 in the heat dissipation fin group respectively corresponding to the at least one fan body 2431 is a second region A2. Referring to FIG. 18, an orthogonal projection of the second group of heat generation devices 222b on the heat dissipation plate 231 is a second projection K2. The orthogonal projection of the second group of heat generation devices 222b on the heat dissipation plate 231 is a projection of the second group of heat generation devices 222b on the heat dissipation plate 231 in the Z-axis direction. The second projection K2 overlaps the second region A2. In this way, a heat dissipation path between the second group of heat generation devices 222b and the plurality of second heat dissipation fins 2452 is short, so that heat dissipation efficiency of the second group of heat generation devices 222b can be improved by using the plurality of second heat dissipation fins 2452.

In some embodiments, referring to FIG. 18, an orthogonal projection of the third group of heat generation devices 222c on the heat dissipation plate 231 is a third projection K3. The orthogonal projection of the third group of heat generation devices 222c on the heat dissipation plate 231 is an orthogonal projection of the third group of heat generation devices 222c on the heat dissipation plate 231 in the Z-axis direction. An orthogonal projection of the fourth group of heat generation devices 222d on the heat dissipation plate 231 is a fourth projection K4. The orthogonal projection of the fourth group of heat generation devices 222d on the heat dissipation plate 231 is a projection of the fourth group of heat generation devices 222d on the heat dissipation plate 231 in the Z-axis direction. Both the third projection K3 and the fourth projection K4 are located on a part of the heat dissipation plate 231 in which the main space 241b is located. In this way, heat dissipation processing can be performed on the third group of heat generation devices 222c and the fourth group of heat generation devices 222d by using the airflow in the fan housing.

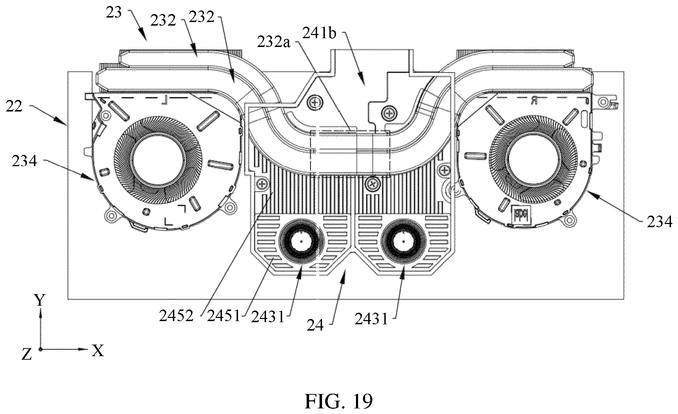

Based on the descriptions in the foregoing embodiments, it should be noted that the host 20 may include only the second heat dissipation system 24, and does not include the foregoing first heat dissipation system 23, or may include the foregoing first heat dissipation system 23 while including the foregoing second heat dissipation system 24. For example, reference is made to FIG. 19. FIG. 19 is a schematic diagram of an assembly structure of a circuit board assembly 22, a first heat dissipation system 23, and a second heat dissipation system 24 in FIG. 5 and FIG. 6. The host 20 includes both the first heat dissipation system 23 and the second heat dissipation system 24, to perform heat dissipation processing on the circuit board assembly 22 by using both the first heat dissipation system 23 and the second heat dissipation system 24, so that heat dissipation efficiency of the circuit board assembly can be improved, and performance and user experience of the entire computer can be ensured.

On the foregoing basis, optionally, still referring to FIG. 19, the evaporation section 232a of the heat pipe 232 in the first heat dissipation system 23 is disposed in the internal space 241 of the fan housing of the second heat dissipation system 24. In this way, heat of the evaporation section 232a is transferred to the condensation section 232b, to be further carried to the outside of the host by the airflow generated by the first fan 234. In addition, the heat of the evaporation section is further in direct contact with the airflow in the fan housing for heat exchange, to be directly carried to the outside of the host 20 by the airflow generated by the second fan 243. Therefore, heat dissipation efficiency of the circuit board assembly 22 can be improved.

In some embodiments, referring to FIG. 19, the evaporation section 232a is located on a side that is of the plurality of second heat dissipation fins 2452 and that is away from the two rows of first heat dissipation fins 2451. In some embodiments, the evaporation section 232a is located in the main space 241b of the fan housing. In this way, after the airflow in the fan housing exchanges heat with the first group of heat generation devices 222a and the second group of heat generation devices 222b, the airflow is in contact with the evaporation section 232a for heat exchange, so that heat dissipation efficiency of the first group of heat generation devices 222a and the second group of heat generation devices 222b can be ensured.

Because noise is inevitably generated when the fan runs, in the embodiment shown in FIG. 19, the fan includes two fan bodies 2431 of the second fan 243 and two first fans 234. Because there are a large quantity of fans, if the fans run at the same time, large noise is generated. This affects user experience.

To avoid the foregoing problem, in some embodiments, the host 20 may further include a detection apparatus and a controller. The detection apparatus is configured to detect power consumption of the at least one heat generation device 222. The controller is electrically connected to the detection apparatus and the second fan 243, and the controller is configured to control running of the second fan 243 based on power consumption of the at least one heat generation device 222 detected by the detection apparatus.

Specifically, when the power consumption of the at least one heat generation device 222 detected by the detection apparatus is less than full-load power consumption of the at least one heat generation device 222, the controller controls the second fan 243 to stop. When the power consumption of the at least one heat generation device 222 detected by the detection apparatus is greater than or equal to full-load power consumption of the at least one heat generation device 222, the controller controls the second fan 243 to run.

In this way, the second fan 243 is started only when the at least one heat generation device 222 runs with full load, so that a problem of large noise can be resolved to some extent, thereby improving user experience.

Compared with the conventional technology, in the embodiment shown in FIG. 19, the second heat dissipation system 24 is added on the basis of the first heat dissipation system 23, to dissipate heat for the circuit board assembly by using both the first heat dissipation system 23 and the second heat dissipation system 24, so that heat dissipation performance of the entire computer can be improved. Power consumption taken away by the second heat dissipation system 24 is an amount of improvement in heat dissipation performance of the entire computer. The power consumption taken away by the second heat dissipation system 24 is calculated as follows:

A total airflow of the two fan bodies 2431 of the second fan 243 is about 2.6 CFM, airflow temperature is about 50°C, an airflow density is about 1.093 Kg/m³, impedance efficiency of the second heat dissipation system 24 is about 40%, airflow temperature of the first air outlet structure 213a is 35°C, a temperature difference between the airflow in the first air inlet structure 212a and the airflow in the air outlet structure is 10°C, and the specific heat capacity of the airflow is 1006.9 J/(kg*K). In this case, the power consumption that can be taken away by the second heat dissipation system 24 is calculated as Q=(2.6*0.4/2119)*1.093*1006.9*10=5.4 W. Therefore, compared with the conventional technology, in the embodiment shown in FIG. 19, additional 5.4 W of power consumption may be taken away from the circuit board assembly 22. Therefore, heat dissipation performance is effectively improved.

In the descriptions of this specification, specific features, structures, materials, or characteristics may be properly combined in any one or more embodiments or examples.

The protection scope of the claims are to be interpreted in accordance with Art. 69 of the EPC protocol.

## Claims

1. A notebook computer (100), comprising a host (20), wherein the host (20) comprises:
a host housing (20, 21), comprising a first wall plate (211) and a second wall plate (212) that are opposite to each other and that are spaced apart, and a third wall plate (213) connected between the first wall plate (211) and the second wall plate (212), wherein a first air outlet structure (213a) is disposed on the second wall plate (212) and/or the third wall plate (213);
two first fans, disposed in the host housing (20, 21), wherein the two first fans are arranged at intervals;
a second fan (243), disposed in the host housing (20, 21) and located between the two first fans, wherein the second fan (243) has an air inlet and an air outlet, the air inlet of the second fan (243) communicates with at least one first air inlet structure (212) disposed on the second wall plate (212), and the air outlet of the second fan communicates with the first air outlet structure (213a);
a circuit board assembly (22), disposed in the host housing (20, 21), wherein the circuit board assembly (22) comprises a circuit board (221) and at least one heat generation device (222, 222a-d) disposed on the circuit board (221);
a heat dissipation plate (231), disposed between the circuit board assembly (22) and the second wall plate (212), wherein the heat dissipation plate (231) is thermally conductive with the at least one heat generation device (222, 222a-d), the second fan (243) comprises at least one fan body (2431) and a fan housing, the at least one fan body (2431) is located between the heat dissipation plate (231) and the second wall plate (212), the fan housing covers the outside of the at least one fan body (2431), and the heat dissipation plate (231) forms one wall plate (214-216) of the fan housing; and
a heat dissipation fin (245, 2451, 2452), disposed on a surface of the heat dissipation plate (231) away from the circuit board assembly (22), wherein the heat dissipation fin (245, 2451, 2452) is located in the internal space (241) of the fan housing;
wherein there are a plurality of heat dissipation fins (245, 2451, 2452), the plurality of heat dissipation fins (245, 2451, 2452) form at least one heat dissipation fin group, and a quantity of the at least one heat dissipation fin group is equal to a quantity of the at least one fan body (2431) and the at least one heat dissipation fin group is in a one-to-one correspondence with the at least one fan body (2431);
the fan body (2431) has a first side and a second side that are opposite to each other, and an arrangement direction of the first side and the second side is parallel to the third wall plate (213);
the heat dissipation fin group corresponding to the fan body (2431) comprises two rows of first heat dissipation fins (2451), and the two rows of first heat dissipation fins (2451) are respectively located on the first side and the second side of the fan body (2431); and
each row of first heat dissipation fins (2451) comprises a plurality of first heat dissipation fins (2451), the plurality of first heat dissipation fins (2451) are arranged at intervals in a direction perpendicular to the third wall plate (213), and each first heat dissipation fin (245, 2451, 2452) extends in the direction parallel to the third wall plate (213).

2. The notebook computer (100) according to claim 1, wherein the second wall plate (212) forms another wall plate (214-216) of the fan housing opposite to the heat dissipation plate (231).

3. The notebook computer (100) according to claim 1 or 2, wherein the fan body (2431) comprises a central shaft and a plurality of blades disposed around the central shaft, the central shaft of the at least one fan body (2431) is perpendicular to the second wall plate (212), and the blade of the at least one fan body (2431) is a centrifugal blade.

4. The notebook computer (100) according to any one of claims 1-3, wherein there are a plurality of fan bodies (2431), and the plurality of fan bodies (2431) are arranged at intervals in a direction parallel to the third wall plate (213).

5. The notebook computer (100) according to claim 4, wherein a separator (244) is disposed between two adjacent fan bodies (2431), the separator (244) separates an internal space (241) of the fan housing into a plurality of sub-spaces (241a), and the plurality of fan bodies (2431) are respectively located in the plurality of sub-spaces (241a); and
the internal space (241) of the fan housing further comprises a main space (241b) located between the plurality of sub-spaces (241a) and the first air outlet structure (213a), the plurality of sub-spaces communicate with the main space (241b), and the main space communicates with the first air outlet structure (213a).

6. The notebook computer (100) according to claim 1, wherein an occupation region, on the heat dissipation plate (231), of the at least one fan body (2431) and the two rows of first heat dissipation fins (2451) in the heat dissipation fin group respectively corresponding to the at least one fan body (2431) is a first region;
the at least one heat generation device (222, 222a-d) comprises a first group of heat generation devices (222, 222a-d); and
an orthogonal projection of the first group of heat generation devices (222, 222a-d) on the heat dissipation plate (231) overlaps the first region.

7. The notebook computer (100) according to claim 6, wherein the heat dissipation fin group corresponding to the fan body (2431) further comprises a plurality of second heat dissipation fins (2452); and
the plurality of second heat dissipation fins (2452) are located between the fan body (2431) and the first air outlet structure (213a), the plurality of second heat dissipation fins (2452) are arranged at intervals in the direction parallel to the third wall plate (213), and each second heat dissipation fin (245, 2451, 2452) extends in the direction perpendicular to the third wall plate (213).

8. The notebook computer (100) according to claim 7, wherein the plurality of second heat dissipation fins (2452) are further located between the two rows of first heat dissipation fins (2451) and the at least one second air outlet structure, and the plurality of second heat dissipation fins (2452) are spaced apart from the two rows of first heat dissipation fins (2451).

9. The notebook computer (100) according to claim 7 or 8, wherein an occupation region, on the heat dissipation plate (231), of the plurality of second heat dissipation fins (2452) in the heat dissipation fin group respectively corresponding to the at least one fan body (2431) is a second region;
the at least one heat generation device (222, 222a-d) further comprises a second group of heat generation devices (222, 222a-d); and
an orthogonal projection of the second group of heat generation devices (222, 222a-d) on the heat dissipation plate (231) overlaps the second region.

10. The notebook computer (100) according to any one of claims 7-9, wherein the host (20) further comprises:
a heat pipe (232), comprising an evaporation section (232a) and two condensation sections, wherein the evaporation section (232a) is located on a side that is of the heat dissipation plate (231) and that is away from the circuit board assembly (22), the evaporation section (232a) is thermally conductive with the heat dissipation plate (231), and the two condensation sections are respectively connected to two ends of the evaporation section (232a) in a length direction; and
two groups of fins, respectively disposed outside the two condensation sections, and being thermally conductive with pipe housings of the two condensation sections, wherein the two groups of fins are respectively located on air outlet sides of the two first fans.

11. The notebook computer (100) according to claim 10, wherein the evaporation section (232a) is located in the internal space (241) of the fan housing, and the evaporation section (232a) is located on a side that is of the plurality of second heat dissipation fins (2452) and that is away from the fan body (2431).

12. The notebook computer (100) according to claim 10 or 11, wherein the at least one heat generation device (222, 222a-d) further comprises a third group of heat generation devices (222, 222a-d), and an orthogonal projection of the third group of heat generation devices (222, 222a-d) on the heat dissipation plate (231) overlaps an orthogonal projection of the evaporation section (232a) on the heat dissipation plate (231).

13. The notebook computer (100) according to claim 2, wherein the host (20) further comprises:
an air baffle strip (242), disposed between the heat dissipation plate (231) and the second wall plate (212), and surrounding the at least one fan body (2431), wherein the air baffle strip (242) forms a side wall of the fan housing.

14. The notebook computer (100) according to any one of claims 1-13, wherein the heat dissipation plate (231) comprises a heat dissipation plate body (2311) and a thermally conductive insert; and
an opening (2311a) is disposed at a position that is on the heat dissipation plate body (2311) and that is opposite to the heat generation device (222, 222a-d), the thermally conductive insert is disposed in the opening (2311a), the heat generation device (222, 222a-d) is thermally conductive with the thermally conductive insert, and an edge of the thermally conductive insert is thermally conductive with an edge of the heat dissipation plate body (2311) at the opening (2311a).

15. The notebook computer (100) according to any one of claims 1-14, wherein the host (20) further comprises a detection apparatus and a controller;
the detection apparatus is configured to detect power consumption of the at least one heat generation device (222, 222a-d); and
the controller is electrically connected to the detection apparatus and the second fan (243), and the controller is configured to control running of the second fan (243) based on power consumption of the at least one heat generation device (222, 222a-d) detected by the detection apparatus.

## Patentansprüche

1. Ein Notebook-Computer (100), umfassend ein Host (20), wobei der Host (20) folgendes umfasst:
ein Host-Gehäuse (20, 21), das eine erste Wandplatte (211) und eine zweite Wandplatte (212) umfasst, die einander gegenüberliegen und voneinander beabstandet sind, sowie eine dritte Wandplatte (213), die zwischen der ersten Wandplatte (211) und der zweiten Wandplatte (212) verbunden ist, wobei eine erste Luftaustrittsstruktur (213a) auf der zweiten Wandplatte (212) und/oder der dritten Wandplatte (213) angeordnet ist;
zwei erste Lüfter, die im Host-Gehäuse (20, 21) angeordnet sind, wobei die beiden ersten Lüfter mit Abstand zueinander angeordnet sind;
ein zweiter Lüfter (243), der im Host-Gehäuse (20, 21) angeordnet und zwischen den beiden ersten Lüftern positioniert ist, wobei der zweite Lüfter (243) über einen Lufteinlass und einen Luftauslass verfügt, der Lufteinlass des zweiten Lüfters (243) mit mindestens einer ersten Lufteinlassstruktur (212) auf der zweiten Wandplatte (212) verbunden ist und der Luftauslass des zweiten Lüfters mit der ersten Luftaustrittsstruktur (213a) kommuniziert;
eine Leiterplattenanordnung (22), die im Host-Gehäuse (20, 21) angeordnet ist, wobei die Leiterplattenanordnung (22) eine Leiterplatte (221) und mindestens eine Wärmeerzeugungseinrichtung (222, 222a-d) auf der Leiterplatte (221) umfasst;
eine Wärmeableitplatte (231), die zwischen der Leiterplattenanordnung (22) und der zweiten Wandplatte (212) angeordnet ist, wobei die Wärmeableitplatte (231) thermisch leitend mit mindestens einer Wärmeerzeugungseinrichtung (222, 222a-d) verbunden ist; der zweite Lüfter (243) umfasst mindestens einen Lüfterkörper (2431) und ein Lüftergehäuse; der mindestens eine Lüfterkörper (2431) befindet sich zwischen der Wärmeableitplatte (231) und der zweiten Wandplatte (212); das Lüftergehäuse umgibt den mindestens einen Lüfterkörper (2431) von außen, und die Wärmeableitplatte (231) bildet eine Wandplatte (214-216) des Lüftergehäuses; und
eine Wärmeableitrippe (245, 2451, 2452), die auf einer der Leiterplattenanordnung (22) abgewandten Oberfläche der Wärmeableitplatte (231) angeordnet ist, wobei sich die Wärmeableitrippe (245, 2451, 2452) im Innenraum (241) des Lüftergehäuses befindet;
wobei mehrere Wärmeableitrippen (245, 2451, 2452) vorhanden sind, wobei die mehreren Wärmeableitrippen (245, 2451, 2452) mindestens eine Wärmeableitrippengruppe bilden und die Anzahl der mindestens einen Wärmeableitrippengruppe gleich der Anzahl der mindestens einen Lüfterkörper (2431) ist, und mindestens eine Wärmeableitrippengruppe entspricht jeweils einem Lüfterkörper (2431) im Eins-zu-eins-Verhältnis;
wobei der Lüfterkörper (2431) eine erste Seite und eine zweite Seite aufweist, die einander gegenüberliegen, und die Anordnungsrichtung der ersten Seite und der zweiten Seite parallel zur dritten Wandplatte (213) verläuft;
Die zum Lüfterkörper (2431) gehörende Gruppe von Wärmeableitungsrippen umfasst zwei Reihen erster Wärmeableitungsrippen (2451), wobei sich die beiden Reihen erster Wärmeableitungsrippen (2451) jeweils auf der ersten und der zweiten Seite des Lüfterkörpers (2431) befinden; und
Jede Reihe der ersten Wärmeableitungsrippen (2451) umfasst mehrere erste Wärmeableitungsrippen (2451), die mehreren ersten Wärmeableitungsrippen (2451) sind in einem Abstand zueinander in einer Richtung senkrecht zur dritten Wandplatte (213) angeordnet, und jede erste Wärmeableitungsrippe (245, 2451, 2452) erstreckt sich in einer Richtung parallel zur dritten Wandplatte (213).

2. Der Notebook-Computer (100) nach Anspruch 1, wobei die zweite Wandplatte (212) eine weitere Wandplatte (214-216) des Lüftergehäuses bildet, die der Wärmeableitungsplatte (231) gegenüberliegt.

3. Der Notebook-Computer (100) nach Anspruch 1 oder 2, wobei der Lüfterkörper (2431) eine zentrale Achse und mehrere um die zentrale Achse angeordnete Schaufeln umfasst, die zentrale Achse des mindestens einen Lüfterkörpers (2431) senkrecht zur zweiten Wandplatte (212) steht und die Schaufel des mindestens einen Lüfterkörpers (2431) eine Zentrifugalschaufel ist.

4. Der Notebook-Computer (100) nach einem der Ansprüche 1-3, wobei mehrere Lüfterkörper (2431) vorhanden sind und die mehreren Lüfterkörper (2431) in einem Abstand in einer Richtung parallel zur dritten Wandplatte (213) angeordnet sind.

5. Der Notebook-Computer (100) nach Anspruch 4, wobei ein Trenner (244) zwischen zwei benachbarten Lüfterkörpern (2431) angeordnet ist, wobei der Trenner (244) einen Innenraum (241) des Lüftergehäuses in mehrere Teilräume (241a) unterteilt und die mehreren Lüfterkörper (2431) sich jeweils in den mehreren Teilräumen (241a) befinden; und
der Innenraum (241) des Lüftergehäuses umfasst weiterhin einen Hauptraum (241b), der sich zwischen den mehreren Teilräumen (241a) und der ersten Luftaustrittsstruktur (213a) befindet, wobei die mehreren Teilräume mit dem Hauptraum (241b) kommunizieren und der Hauptraum mit der ersten Luftaustrittsstruktur (213a) kommuniziert.

6. Der Notebook-Computer (100) nach Anspruch 1, wobei ein belegter Bereich auf der Wärmeableitungsplatte (231) des mindestens einen Lüfterkörpers (2431) und der zwei Reihen von ersten Wärmeableitungsrippen (2451) in der Wärmeableitungsrippengruppe, die jeweils dem mindestens einen Lüfterkörper (2431) zugeordnet sind, als ein erster Bereich definiert ist;
das mindestens eine wärmeerzeugende Bauteil (222, 222a-d) umfasst eine erste Gruppe von wärmeerzeugenden Bauteilen (222, 222a-d); und
eine orthogonale Projektion der ersten Gruppe wärmeerzeugender Bauteile (222, 222a-d) auf die Wärmeableitungsplatte (231) überlappt den ersten Bereich.

7. Das Notebook (100) nach Anspruch 6, wobei die mit dem Lüftergehäuse (2431) korrespondierende Kühlrippen-Gruppe weiterhin eine Vielzahl von zweiten Kühlrippen (2452) umfasst; und
die Vielzahl von zweiten Kühlrippen (2452) befinden sich zwischen dem Lüftergehäuse (2431) und der ersten Luftauslassstruktur (213a), die Vielzahl von zweiten Kühlrippen (2452) sind im Abstand in der Richtung parallel zur dritten Wandplatte (213) angeordnet, und jede zweite Kühlrippe (245, 2451, 2452) erstreckt sich in einer zur dritten Wandplatte (213) senkrechten Richtung.

8. Das Notebook (100) nach Anspruch 7, wobei die Vielzahl von zweiten Kühlrippen (2452) sich zudem zwischen den beiden Reihen von ersten Kühlrippen (2451) und mindestens einer zweiten Luftauslassstruktur befinden und die Vielzahl von zweiten Kühlrippen (2452) von den beiden Reihen der ersten Kühlrippen (2451) voneinander beabstandet sind.

9. Das Notebook (100) nach Anspruch 7 oder 8, wobei ein belegter Bereich auf der Kühlplatte (231) durch die Vielzahl von zweiten Kühlrippen (2452) in der Kühlrippen-Gruppe jeweils dem mindestens einen Lüftergehäuse (2431) entspricht und als zweiter Bereich bezeichnet wird;
das mindestens eine Wärme erzeugende Gerät (222, 222a-d) umfasst weiterhin eine zweite Gruppe von wärmeerzeugenden Geräten (222, 222a-d); und
eine orthogonale Projektion der zweiten Gruppe von wärmeerzeugenden Geräten (222, 222a-d) auf die Kühlplatte (231) überlappt den zweiten Bereich.

10. Das Notebook (100) nach einem der Ansprüche 7-9, wobei das Host (20) weiterhin umfasst:
ein Wärmerohr (232), das einen Verdampfungsteil (232a) und zwei Kondensationsteile umfasst, wobei der Verdampfungsteil (232a) an einer Seite der Kühlplatte (231) liegt, die von der Leiterplattenbaugruppe (22) abgewandt ist, der Verdampfungsteil (232a) thermisch leitend mit der Kühlplatte (231) verbunden ist und die beiden Kondensationsteile jeweils mit den beiden Enden des Verdampfungsteils (232a) in Längsrichtung verbunden sind; und
zwei Gruppen von Kühlrippen, die jeweils außerhalb der zwei Kondensationsteile angeordnet und thermisch leitend mit den Rohrgehäusen der zwei Kondensationsteile verbunden sind, wobei die beiden Gruppen von Kühlrippen sich jeweils auf den Luftauslassseiten der beiden ersten Lüfter befinden.

11. Das Notebook (100) nach Anspruch 10, wobei sich der Verdampfungsteil (232a) im Innenraum (241) des Lüftergehäuses befindet und der Verdampfungsteil (232a) sich auf einer Seite der Vielzahl von zweiten Kühlrippen (2452) befindet, die vom Lüftergehäuse (2431) abgewandt ist.

12. Das Notebook-Computer (100) nach Anspruch 10 oder 11, wobei die zumindest eine Wärme erzeugende Vorrichtung (222, 222a-d) weiterhin eine dritte Gruppe von Wärme erzeugenden Vorrichtungen (222, 222a-d) umfasst, und wobei eine orthogonale Projektion der dritten Gruppe von Wärme erzeugenden Vorrichtungen (222, 222a-d) auf die Wärmeableitplatte (231) mit einer orthogonalen Projektion des Verdampferabschnitts (232a) auf die Wärmeableitplatte (231) überlappt.

13. Das Notebook-Computer (100) nach Anspruch 2, wobei das Hostgerät (20) weiterhin Folgendes umfasst:
einen Luftleiste (242), angeordnet zwischen der Wärmeableitplatte (231) und der zweiten Wandplatte (212) und um den zumindest einen Lüfterkörper (2431) herum, wobei die Luftleiste (242) eine Seitenwand des Lüftergehäuses bildet.

14. Das Notebook-Computer (100) nach einem der Ansprüche 1-13, wobei die Wärmeableitplatte (231) einen Wärmeableitplattenkörper (2311) und einen wärmeleitenden Einsatz umfasst; und
eine Öffnung (2311a) ist an einer Position vorgesehen, die sich am Wärmeableitplattenkörper (2311) und gegenüber der Wärmeerzeugungsvorrichtung (222, 222a-d) befindet. Der wärmeleitende Einsatz ist in der Öffnung (2311a) angeordnet, die Wärmeerzeugungsvorrichtung (222, 222a-d) steht wärmeleitend mit dem wärmeleitenden Einsatz in Verbindung, und eine Kante des wärmeleitenden Einsatzes steht wärmeleitend mit einer Kante des Wärmeableitplattenkörpers (2311) an der Öffnung (2311a) in Verbindung.

15. Das Notebook-Computer (100) nach einem der Ansprüche 1-14, wobei das Hostgerät (20) weiterhin eine Detektionseinrichtung und einen Controller umfasst;
Die Detektionseinrichtung ist konfiguriert, den Energieverbrauch der zumindest einen Wärmeerzeugungsvorrichtung (222, 222a-d) zu erfassen; und
Der Controller ist elektrisch mit der Detektionseinrichtung und dem zweiten Lüfter (243) verbunden und konfiguriert, den Betrieb des zweiten Lüfters (243) basierend auf dem von der Detektionseinrichtung erkannten Energieverbrauch der zumindest einen Wärmeerzeugungsvorrichtung (222, 222a-d) zu steuern.

## Revendications

1. Un ordinateur portable (100), comprenant un hôte (20), dans lequel l'hôte (20) comprend :
un boîtier d'hôte (20, 21), comprenant une première plaque murale (211) et une seconde plaque murale (212) qui se font face et sont espacées, et une troisième plaque murale (213) connectée entre la première plaque murale (211) et la seconde plaque murale (212), une première structure de sortie d'air (213a) étant disposée sur la seconde plaque murale (212) et/ou la troisième plaque murale (213) ;
deux premiers ventilateurs, disposés dans le boîtier d'hôte (20, 21), les deux premiers ventilateurs étant espacés l'un de l'autre ;
un deuxième ventilateur (243), disposé dans le boîtier d'hôte (20, 21) et situé entre les deux premiers ventilateurs, le deuxième ventilateur (243) ayant une entrée d'air et une sortie d'air, l'entrée d'air du deuxième ventilateur (243) communiquant avec au moins une première structure d'entrée d'air (212) disposée sur la seconde plaque murale (212) et la sortie d'air du deuxième ventilateur communiquant avec la première structure de sortie d'air (213a) ;
un ensemble carte de circuit imprimé (22), disposé dans le boîtier d'hôte (20, 21), l'ensemble carte de circuit imprimé (22) comprenant une carte de circuit imprimé (221) et au moins un dispositif générateur de chaleur (222, 222a-d) disposé sur la carte (221) ;
une plaque de dissipation thermique (231), disposée entre l'ensemble carte de circuit imprimé (22) et la seconde plaque murale (212), la plaque de dissipation thermique (231) étant conductrice de chaleur avec le ou les dispositifs générateurs de chaleur (222, 222a-d), le deuxième ventilateur (243) comprenant au moins un corps de ventilateur (2431) et un carter de ventilateur, le ou les corps de ventilateur (2431) étant situés entre la plaque de dissipation thermique (231) et la seconde plaque murale (212), le carter de ventilateur recouvrant l'extérieur du ou des corps de ventilateur (2431), et la plaque de dissipation thermique (231) formant une plaque murale (214-216) du carter de ventilateur ; et
une ailette de dissipation thermique (245, 2451, 2452), disposée sur une surface de la plaque de dissipation thermique (231) opposée à celle de l'ensemble carte de circuit imprimé (22), l'ailette de dissipation thermique (245, 2451, 2452) étant localisée dans l'espace interne (241) du carter de ventilateur ;
dans lequel il y a une pluralité d'ailettes de dissipation thermique (245, 2451, 2452), la pluralité d'ailettes de dissipation thermique (245, 2451, 2452) forme au moins un groupe d'ailettes de dissipation thermique, la quantité du ou des groupes d'ailettes de dissipation thermique étant égale à la quantité du ou des corps de ventilateur (2431), et chaque groupe d'ailettes de dissipation thermique correspond un à un à chaque corps de ventilateur (2431) ;
le corps de ventilateur (2431) présente un premier côté et un deuxième côté, opposés l'un à l'autre, et la direction d'agencement du premier et du deuxième côté est parallèle à la troisième plaque murale (213) ;
le groupe d'ailettes de dissipation thermique correspondant au corps du ventilateur (2431) comprend deux rangées de premières ailettes de dissipation thermique (2451), et les deux rangées de premières ailettes de dissipation thermique (2451) sont respectivement situées sur le premier côté et le second côté du corps du ventilateur (2431) ; et
chaque rangée de premières ailettes de dissipation thermique (2451) comprend une pluralité de premières ailettes de dissipation thermique (2451), lesquelles sont disposées à intervalles sur une direction perpendiculaire à la troisième plaque murale (213), et chaque première ailette de dissipation thermique (245, 2451, 2452) s'étend dans une direction parallèle à la troisième plaque murale (213).

2. L'ordinateur portable (100) selon la revendication 1, dans lequel la seconde plaque murale (212) constitue une autre plaque murale (214-216) du boîtier du ventilateur opposée à la plaque de dissipation thermique (231).

3. L'ordinateur portable (100) selon la revendication 1 ou 2, dans lequel le corps du ventilateur (2431) comprend un arbre central et une pluralité de pales disposées autour de l'arbre central, l'arbre central d'au moins un corps de ventilateur (2431) étant perpendiculaire à la seconde plaque murale (212), et la pale d'au moins un corps de ventilateur (2431) étant une pale centrifuge.

4. L'ordinateur portable (100) selon l'une quelconque des revendications 1 à 3, dans lequel il y a une pluralité de corps de ventilateurs (2431), et ces corps de ventilateurs (2431) sont disposés à intervalles dans une direction parallèle à la troisième plaque murale (213).

5. L'ordinateur portable (100) selon la revendication 4, dans lequel un séparateur (244) est disposé entre deux corps de ventilateurs (2431) adjacents, le séparateur (244) sépare l'espace interne (241) du boîtier du ventilateur en une pluralité de sous-espaces (241a), et les corps de ventilateurs (2431) sont respectivement placés dans les différents sous-espaces (241a) ; et
l'espace interne (241) du boîtier du ventilateur comprend en outre un espace principal (241b) situé entre les sous-espaces (241a) et la première structure de sortie d'air (213a), les sous-espaces communiquent avec l'espace principal (241b), et l'espace principal communique avec la première structure de sortie d'air (213a).

6. L'ordinateur portable (100) selon la revendication 1, dans lequel une région occupée sur la plaque de dissipation thermique (231), du ou des corps de ventilateur (2431) et des deux rangées de premières ailettes de dissipation thermique (2451) dans le groupe d'ailettes de dissipation thermique correspondant au ou aux corps de ventilateur (2431), constitue une première région ;
le ou les dispositifs de génération de chaleur (222, 222a-d) comprennent un premier groupe de dispositifs de génération de chaleur (222, 222a-d) ; et
une projection orthogonale du premier groupe de dispositifs de génération de chaleur (222, 222a-d) sur la plaque de dissipation thermique (231) chevauche la première région.

7. L'ordinateur portable (100) selon la revendication 6, dans lequel le groupe d'ailettes de dissipation thermique correspondant au corps du ventilateur (2431) comprend en outre une pluralité de deuxièmes ailettes de dissipation thermique (2452) ; et
la pluralité de deuxièmes ailettes de dissipation thermique (2452) est située entre le corps du ventilateur (2431) et la première structure de sortie d'air (213a), la pluralité de deuxièmes ailettes de dissipation thermique (2452) est disposée à intervalles dans la direction parallèle à la troisième plaque murale (213), et chaque deuxième ailette de dissipation thermique (245, 2451, 2452) s'étend dans la direction perpendiculaire à la troisième plaque murale (213).

8. L'ordinateur portable (100) selon la revendication 7, dans lequel la pluralité de deuxièmes ailettes de dissipation thermique (2452) est en outre située entre les deux rangées de premières ailettes de dissipation thermique (2451) et au moins une deuxième structure de sortie d'air, et la pluralité de deuxièmes ailettes de dissipation thermique (2452) est espacée des deux rangées de premières ailettes de dissipation thermique (2451).

9. L'ordinateur portable (100) selon la revendication 7 ou 8, dans lequel une zone d'occupation, sur la plaque de dissipation thermique (231), de la pluralité de deuxièmes ailettes de dissipation thermique (2452) dans le groupe d'ailettes de dissipation thermique correspondant respectivement à au moins un corps de ventilateur (2431), est une deuxième région ;
au moins un dispositif de génération de chaleur (222, 222a-d) comprend également un deuxième groupe de dispositifs de génération de chaleur (222, 222a-d) ; et
la projection orthogonale du deuxième groupe de dispositifs de génération de chaleur (222, 222a-d) sur la plaque de dissipation thermique (231) chevauche la deuxième région.

10. L'ordinateur portable (100) selon l'une quelconque des revendications 7 à 9, dans lequel l'unité centrale (20) comprend en outre :
un caloduc (232), comprenant une section d'évaporation (232a) et deux sections de condensation, dans lequel la section d'évaporation (232a) est située sur un côté de la plaque de dissipation thermique (231) opposé à l'ensemble du circuit imprimé (22), la section d'évaporation (232a) est thermiquement conductrice avec la plaque de dissipation thermique (231), et les deux sections de condensation sont respectivement connectées aux deux extrémités de la section d'évaporation (232a) dans la direction de la longueur ; et
deux groupes d'ailettes, disposés respectivement à l'extérieur des deux sections de condensation, et étant thermiquement conducteurs avec les gaines des deux sections de condensation, dans lequel les deux groupes d'ailettes sont respectivement situés du côté des sorties d'air des deux premiers ventilateurs.

11. L'ordinateur portable (100) selon la revendication 10, dans lequel la section d'évaporation (232a) est située dans l'espace interne (241) du boîtier du ventilateur, et la section d'évaporation (232a) est située du côté de la pluralité de deuxièmes ailettes de dissipation thermique (2452) opposé au corps du ventilateur (2431).

12. L'ordinateur portable (100) selon la revendication 10 ou 11, dans lequel au moins un dispositif de génération de chaleur (222, 222a-d) comprend en outre un troisième groupe de dispositifs de génération de chaleur (222, 222a-d), et la projection orthogonale du troisième groupe de dispositifs de génération de chaleur (222, 222a-d) sur la plaque de dissipation thermique (231) chevauche la projection orthogonale de la section d'évaporation (232a) sur la plaque de dissipation thermique (231).

13. L'ordinateur portable (100) selon la revendication 2, dans lequel l'hôte (20) comprend en outre :
une bande déflectrice d'air (242), disposée entre la plaque de dissipation thermique (231) et la seconde plaque murale (212), entourant le ou les corps de ventilateur (2431), la bande déflectrice d'air (242) formant une paroi latérale du boîtier du ventilateur.

14. L'ordinateur portable (100) selon l'une quelconque des revendications 1 à 13, dans lequel la plaque de dissipation thermique (231) comprend un corps de plaque de dissipation thermique (2311) et un insert thermiquement conducteur ; et
une ouverture (2311a) est disposée à un emplacement sur le corps de plaque de dissipation thermique (2311) se trouvant en face du dispositif de génération de chaleur (222, 222a-d), l'insert thermiquement conducteur étant placé dans l'ouverture (2311a), le dispositif de génération de chaleur (222, 222a-d) étant en conduction thermique avec l'insert thermiquement conducteur, et un bord de l'insert thermiquement conducteur étant en conduction thermique avec un bord du corps de plaque de dissipation thermique (2311) au niveau de l'ouverture (2311a).

15. L'ordinateur portable (100) selon l'une quelconque des revendications 1 à 14, dans lequel l'hôte (20) comprend en outre un dispositif de détection et un contrôleur ;
le dispositif de détection étant conçu pour détecter la consommation électrique d'au moins un dispositif de génération de chaleur (222, 222a-d) ; et
le contrôleur est électriquement connecté au dispositif de détection et au second ventilateur (243), et il est configuré pour contrôler le fonctionnement du second ventilateur (243) en fonction de la consommation électrique d'au moins un dispositif de génération de chaleur (222, 222a-d) détectée par le dispositif de détection.
